(19) Europäisches Patentamt / European Patent Office / Office européen des brevets

(11) **EP 3 102 956 B1**

(12) **FASCICULE DE BREVET EUROPEEN**

(45) Date de publication et mention
de la délivrance du brevet:
**04.04.2018 Bulletin 2018/14**

(21) Numéro de dépôt: **15703576.7**

(22) Date de dépôt: **09.02.2015**

(51) Int Cl.:
**H03K 5/13** *(2014.01)*          **H03K 5/00** *(2006.01)*
**G01R 31/30** *(2006.01)*          **G01R 31/317** *(2006.01)*

(86) Numéro de dépôt international:
**PCT/EP2015/052614**

(87) Numéro de publication internationale:
**WO 2015/118145 (13.08.2015 Gazette 2015/32)**

(54) **PROCÉDÉ DE CARACTÉRISATION DU FONCTIONNEMENT D'UN CIRCUIT ÉLECTRONIQUE NUMÉRIQUE ET CIRCUIT ÉLECTRONIQUE NUMÉRIQUE**

VERFAHREN ZUR CHARAKTERISIERUNG DES BETRIEBS EINER DIGITALEN ELEKTRONISCHEN SCHALTUNG UND DIGITALE ELEKTRONISCHE SCHALTUNG

METHOD FOR CHARACTERIZING THE OPERATION OF A DIGITAL ELECTRONIC CIRCUIT AND DIGITAL ELECTRONIC CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.02.2014 FR 1450981**
**07.02.2014 FR 1450980**

(43) Date de publication de la demande:
**14.12.2016 Bulletin 2016/50**

(73) Titulaire: **Commissariat à l'Énergie Atomique et aux Énergies Alternatives**
**75015 Paris (FR)**

(72) Inventeur: **MIRO PANADES, Ivan**
**F-38000 Grenoble (FR)**

(74) Mandataire: **Cabinet Camus Lebkiri**
**25 rue de Maubeuge**
**75009 Paris (FR)**

(56) Documents cités:
**WO-A1-2010/122036          US-A1- 2010 153 896**
**US-A1- 2010 188 115**

- **BEIGNE E ET AL: "A fine grain variation-aware dynamic Vdd-hopping AVFS architecture on a 32nm GALS MPSoC", 2013 PROCEEDINGS OF THE ESSCIRC (ESSCIRC), IEEE, 16 septembre 2013 (2013-09-16), pages 57-60, XP032518986, ISSN: 1930-8833, DOI: 10.1109/ESSCIRC.2013.6649071 ISBN: 978-1-4799-0643-7 [extrait le 2013-10-28]**
- **BURD ET AL: "A dynamic voltage scaled microprocessor system", IEEE JOURNAL OF SOLID-STATE CIRCUITS, vol. 35, no. 11, 1 janvier 2000 (2000-01-01), page 1571, XP055003576, ISSN: 0018-9200, DOI: 10.1109/4.881202**
- **YUJI KUNITAKE ET AL: "Possibilities to miss predicting timing errors in canary flip-flops", CIRCUITS AND SYSTEMS (MWSCAS), 2011 IEEE 54TH INTERNATIONAL MIDWEST SYMPOSIUM ON, IEEE, 7 août 2011 (2011-08-07), pages 1-4, XP031941599, DOI: 10.1109/MWSCAS.2011.6026656 ISBN: 978-1-61284-856-3 cité dans la demande**

**Description**

**DOMAINE TECHNIQUE**

La présente invention traite de l'optimisation du fonctionnement d'un circuit électronique numérique, en termes de consommation énergétique ou de vitesse de fonctionnement. Plus particulièrement, l'invention est relative à un procédé de caractérisation, capable de déterminer les conditions optimales de fonctionnement du circuit, et à un circuit dont le fonctionnement est optimisé.

**ETAT DE LA TECHNIQUE**

Les circuits électroniques numériques utilisent une horloge, générant un signal d'horloge à une fréquence préalablement déterminée, dite fréquence d'horloge, pour cadencer les transferts de données entre des éléments séquentiels, par exemple de type bascule. Afin d'améliorer les performances des circuits numériques, on peut chercher à utiliser une fréquence d'horloge la plus élevée possible. On peut également chercher à réduire la tension d'alimentation du circuit, afin de réduire sa consommation énergétique.

Dans ces circuits électroniques numériques, un certain nombre de vérifications, dites vérifications temporelles, doivent être effectuées pour s'assurer que le circuit reste fonctionnel à la fréquence d'horloge et à la tension d'alimentation préconisées. Ces vérifications sont classiquement réalisées par le calcul des temps de propagation sur les chemins de données et d'horloge du circuit, en s'assurant que les contraintes de temps de maintien et d'établissement des bascules ne sont pas violées - on parle de violations temporelles. Le temps d'établissement d'une bascule correspond au temps de stabilité minimum qu'une donnée doit respecter en entrée de la bascule avant que ne se présente le front d'horloge, afin que la donnée soit effectivement prise en compte par la bascule. Le temps de maintien d'une bascule correspond au temps de stabilité minimum qu'une donnée doit respecter en entrée de la bascule après que le front d'horloge s'est présenté, afin qu'elle soit correctement échantillonnée par la bascule.

Les analyses de type pire-cas permettent d'identifier les chemins critiques limitant la fréquence de fonctionnement du circuit et d'estimer de façon réaliste les temps de propagation dans ces chemins. Les chemins critiques correspondent dans la pratique aux chemins susceptibles d'être empruntés par un signal de données et pour lesquels les risques de violations temporelles sont les plus probables. La fréquence d'horloge maximale est alors déterminée par les temps de propagation des chemins critiques, auxquels on ajoute une marge temporelle.

La marge temporelle est définie comme la différence entre le temps d'arrivée escompté du signal de données en entrée de la bascule et le temps d'arrivée induisant une violation de la contrainte temporelle (temps d'établissement et/ou de maintien). Cette marge de sécurité est requise car les temps de propagation des données ne sont pas constants, à cause notamment des variations du processus de fabrication (i.e. variation d'un circuit à l'autre) et des variations environnementales (variation au cours du fonctionnement du circuit). Les variations environnementales sont, par exemple, des baisses locales et temporaires de la tension d'alimentation ou encore des gradients de température.

Les marges temporelles prises lors des analyses pire-cas sont devenues très pessimistes, car toutes ces variations nécessitent la prise en compte de marges temporelles de plus en plus grandes pour être certain de couvrir toutes les éventualités. Le circuit numérique ne peut donc pas être optimisé de façon efficace, lorsque ces méthodes d'analyse classiques sont appliquées.

Les dérives des temps de propagation, dues aux variations dynamiques difficilement prévisibles de température et de tension d'alimentation, rendent indispensable le suivi en ligne des performances du circuit, afin de détecter ces dérives et trouver le point de fonctionnement optimal du circuit en réduisant au mieux les marges temporelles.

Le document [« Possibilities to Miss Predicting Timing Errors in Canary Flip-flops » ; Y. Kunitake et al., Institute of Electrical and Electronics Engineers ; Jan 7, 2011] propose deux solutions pour réaliser un suivi en ligne des performances appelé « ajustement dynamique de la tension » (« Dynamic Voltage Scaling » en anglais). Ces solutions consistent à intégrer dans la fonctionnalité même du circuit un dispositif de détection de violations temporelles et à commander une variation de la tension d'alimentation (ou de la fréquence de fonctionnement : « Dynamic Frequency Scaling ») selon l'occurrence de ces violations temporelles.

Les dispositifs de détection proposés sont couplés à un élément séquentiel de type bascule et visent à déterminer si un signal de données en entrée de la bascule est stable, en comparant entre deux instants la valeur de ce signal. Si la donnée n'est pas stable, il y a de fortes chances que les temps de maintien et d'établissement de la bascule soient violés. Pour échantillonner le signal de données à deux instants, une redondance au niveau de la bascule est mise en oeuvre.

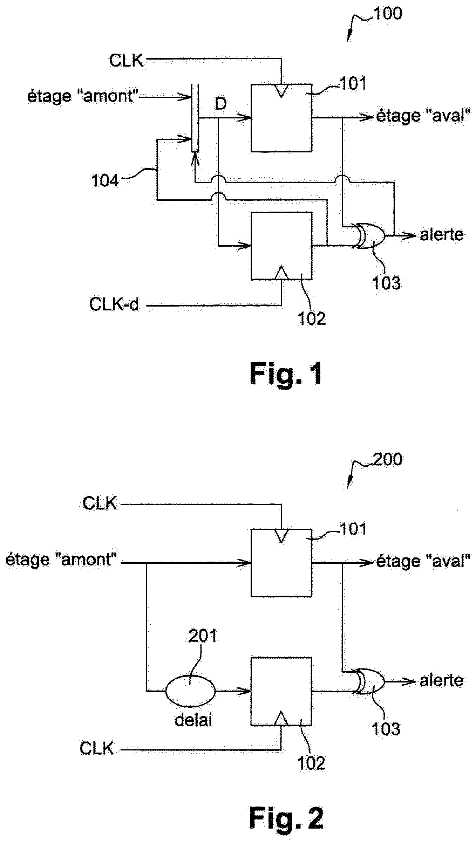

La figure 1 représente un premier dispositif de détection 100, appelé dispositif « Razor » et disposé dans un chemin de données entre deux étages du circuit numérique, un étage amont et un étage aval (non représentés). Une première bascule 101, dite « principale », échantillonne un signal de données D de façon classique au front actif d'un signal d'horloge CLK, tandis qu'une deuxième bascule de suivi 102 échantillonne le même signal D au front actif d'un signal d'horloge retardé CLK-d. L'horloge CLK-d est retardée par rapport à l'horloge CLK de telle sorte que la bascule 102 échantillonne la donnée après le front actif du signal CLK. Puis, à l'aide d'un comparateur 103 connecté aux sorties des bascules 101 et 102, la valeur contenue dans la bascule 101 est comparée à celle de la bascule 102.

Si les deux valeurs sont identiques, on considère que le signal de données D était stable au front actif du signal d'horloge CLK et que, par conséquent, la donnée a été correctement échantillonnée par la bascule principale 101. Si à l'inverse les deux valeurs diffèrent, cela signifie qu'il y a eu une transition du signal de données D entre les deux instants et donc la donnée capturée par la bascule 101 risque de ne pas être exacte. La sortie du comparateur 103 fournit un signal d'alerte, qui indique dans ce cas qu'une faute temporelle s'est produite.

Le dispositif « Razor » comprend un module de rattrapage 104 configuré pour, lorsqu'une faute a été détectée, restaurer la bonne valeur du signal de données D dans la bascule principale 101, à partir de celle échantillonnée par la bascule de suivi 102 (qui est, par hypothèse, toujours correcte). Le module de rattrapage 104 permet de ré-exécuter l'opération à une fréquence plus faible ou une tension plus élevée que la séquence mise en faute.

Pour que ce dispositif détecte une faute, la valeur du signal de données D ne doit pas être modifiée immédiatement après le front actif du signal d'horloge CLK - autrement dit, on veut être certain que la bascule 102 « voit » la bonne valeur du signal de données D pour ensuite la comparer. Le signal de données D doit donc être maintenu au minium jusqu'à l'instant où la bascule 102 échantillonne le signal D. Cela nécessite de rajouter sur les chemins plus courts menant à la bascule principale 101 une ou plusieurs cellules de délais - appelés buffers - qui ralentissent la propagation du signal de données D lorsque le signal emprunte ces chemins plus courts.

Un deuxième dispositif de détection de violations temporelles, nommé « Canary Flip-Flop » dans l'article susmentionné, applique une technique similaire au dispositif « Razor », en ce qu'il compare deux valeurs du signal de données, prises à des instants différents en doublant l'élément séquentiel de type bascule. Toutefois, plutôt que de détecter l'erreur, ce système permet de l'anticiper, en observant l'état du signal de données avant le front actif de l'horloge, et non pas après. On évite ainsi le besoin d'un module de rattrapage.

La figure 2 représente schématiquement un dispositif de détection 200 de type « Canary Flip-Flop ». Les deux bascules 101 et 102 sont ici cadencées par le même signal d'horloge CLK. Grâce à une cellule de délai 201 située en entrée de la bascule de suivi 102 et qui retarde le signal de données D, la bascule 102 échantillonne une valeur du signal D se produisant avant la valeur échantillonnée par la bascule principale 101 dans le cycle d'horloge. Si les deux valeurs en sortie des bascules 101 et 102 sont identiques, cela signifie que la donnée était stable avant le front actif du signal d'horloge. La donnée échantillonnée par la bascule principale 101 peut alors être considérée comme correcte. A l'inverse, si les valeurs diffèrent, cela signifie que le signal de données D n'était pas encore stabilisé et la donnée échantillonnée peut ne pas être la bonne.

Dans l'une ou l'autre de ces solutions, il n'est pas garanti que, entre les deux instants de détection, le signal de données D n'ait pas changé de valeur à deux reprises. Cela signifierait que le signal de données D n'est pas stable. Pour autant, aucune faute ne serait détectée.

Afin d'améliorer la fiabilité de la détection, il a été proposé des capteurs de stabilité, qui observent les transitions du signal de données pendant toute une période de temps - appelée fenêtre de détection - et pas uniquement par comparaison de valeurs entre deux instants. La fenêtre de détection peut être placée avant, autour ou après le front montant, selon qu'on souhaite détecter une violation du temps d'établissement ou du temps de maintien. Un tel dispositif de surveillance est notamment décrit dans la demande WO2010/122036. Le document US 2010/153896 A1 (SEWALL JEREMY 17 juin 2010) divulgue un circuit intégré comprenant un chemin critique et un détecteur de violation de "marge" qui est configuré pour détecter des violations temporelles associées au chemin critique juste avant qu'une erreur du circuit ne se produise. En cas de violation temporelle, une unité de commande reçoit un signal issu du détecteur et adapte la tension d'alimentation pour empêcher la mise en défaut du circuit.

Tous les capteurs de stabilité précités (« Razor », « Canary Flip-Flop » et les dispositifs de surveillance) sont en général couplés aux chemins de données qui sont les plus critiques dans un circuit numérique, c'est-à-dire aux chemins dont les temps de propagation du signal de données sont les plus longs, afin de minimiser la marge de sécurité et faire fonctionner le circuit à une fréquence proche de la fréquence maximale du circuit. Par conséquent, pour que ces capteurs détectent une faute temporelle, il est nécessaire que ces chemins critiques soient activés, c'est-à-dire qu'un signal de données parcourt ces chemins. Or, ces chemins critiques ne sont activés que très rarement.

Le problème est alors le suivant : tant que ces chemins critiques ne sont pas activés, il n'y a pas de fautes détectées et on peut croire que le circuit peut fonctionner à une fréquence d'horloge plus élevée ou à une tension d'alimentation plus faible. Augmenter la fréquence ou diminuer la tension aura pour conséquence de rallonger encore les délais de propagation, par rapport au front actif du signal d'horloge. Il peut alors arriver que ces capteurs ne voient pas une transition du signal de données, car celle-ci se produit bien après la fenêtre de détection. Autrement dit, les capteurs seront devenus aveugles aux violations temporelles se produisant sur les chemins critiques, lorsque ces chemins sont, leur tour venu, parcourus par le signal de données.

Ce problème de détection peut être résolu uniquement dans le cas du système « Razor » en élargissant la fenêtre de détection, ce qui implique d'introduire de nombreuses cellules buffers. Le circuit occupe alors plus de surface et consomme davantage d'énergie.

Par conséquent, aucune des solutions proposées jusqu'à maintenant ne permet d'optimiser au mieux le circuit numérique d'un point de vue énergétique, en minimisant les marges de sécurité prises pour éviter les violations temporelles, tout en garantissant qu'aucune violation temporelle ne se produise.

**RESUME DE L'INVENTION**

L'invention vise à optimiser le fonctionnement d'un circuit électronique numérique, en déterminant un point de fonctionnement qui respecte les contraintes temporelles avec le minimum de marge de sécurité et quel que soit son environnement.

Selon l'invention, on tend à satisfaire ce besoin en prévoyant un procédé de caractérisation d'un circuit intégré consistant à déterminer à un instant donné de la vie du circuit un point de fonctionnement optimal du circuit numérique comprenant :

- une pluralité d'éléments séquentiels ;
- des chemins conducteurs de données entre les éléments séquentiels ;
- un arbre d'horloge délivrant un signal d'horloge pour cadencer les éléments séquentiels ; et
- un capteur de fautes temporelles de type préventif couplé à l'un des éléments séquentiels, recevant en entrée un signal de données arrivant sur l'élément séquentiel et configuré pour détecter, pendant une fenêtre de détection une transition du signal de données ;
- des moyens de réglage d'au moins un premier et un second paramètres de fonctionnement du circuit numérique.

Ce procédé de caractérisation comprend les étapes suivantes :

e) activer un chemin conducteur de données jusqu'à l'élément séquentiel couplé au capteur ;
f) déterminer, pour une valeur donnée du premier paramètre, une première valeur du second paramètre à partir de laquelle le capteur détecte une transition du signal de données pendant la fenêtre de détection, lesdites valeurs des premier et second paramètres définissant un point de fonctionnement de détection du circuit numérique ;
g) déterminer le point de fonctionnement optimal associé au point de fonctionnement de détection, en ajoutant à la première valeur du second paramètre, une marge de correction prédéterminée en lien avec une valeur limite du deuxième paramètre qui entrainerait un dysfonctionnement du circuit numérique pour la valeur donnée du premier paramètre, ladite marge de correction étant associée à la valeur donnée du premier paramètre du point de fonctionnement de détection.

De préférence, la marge de correction prédéterminée est mémorisée dans une mémoire du circuit ou est calculée à partir d'une relation fonctionnelle mémorisée dans le circuit ; les valeurs ou la relation fonctionnelle mémorisées étant obtenues par la mise en oeuvre d'un procédé de calibration décrit ci-dessous.

Les étapes e) à g) sont avantageusement mises en oeuvre pour plusieurs valeurs du premier paramètre.

Dans un mode de mise en oeuvre préférentiel du procédé de caractérisation, le circuit comprend une pluralité de capteurs de fautes temporelles de type préventif couplés chacun à l'un des éléments séquentiels, et les étapes e) à g) sont mises en oeuvre pour chaque capteur, de sorte à obtenir une pluralité de points de fonctionnement corrigés ayant la même valeur du premier paramètre, le procédé comprenant en outre une étape de détermination, à partir de la pluralité de points de fonctionnement corrigés, d'un unique point de fonctionnement optimal associé à la valeur considérée du premier paramètre.

Selon un développement du procédé de caractérisation, l'unique point de fonctionnement optimal est défini par ladite valeur du premier paramètre et une moyenne arithmétique desdites valeurs du second paramètre de la pluralité de points de fonctionnement corrigés.

Selon un autre développement du procédé de caractérisation, le second paramètre est la fréquence du signal d'horloge et l'unique point de fonctionnement optimal est défini par ladite valeur du premier paramètre et de la plus faible desdites valeurs du second paramètre de la pluralité de points de fonctionnement corrigés.

Selon un autre développement du procédé de caractérisation, le second paramètre est la tension d'alimentation du circuit numérique et l'unique point de fonctionnement optimal est défini par ladite valeur du premier paramètre et la plus grande desdites valeurs du second paramètre de la pluralité de points de fonctionnement corrigés.

Un autre aspect de l'invention concerne un procédé de calibration permettant de déterminer la marge de correction. Ce procédé de calibration comprend les étapes suivantes :

a) activer un chemin conducteur de données jusqu'à l'élément séquentiel couplé au capteur ;
b) déterminer, pour une valeur donnée du premier paramètre, une première valeur du second paramètre à partir de laquelle le capteur détecte une transition du signal de données pendant la fenêtre de détection, lesdites valeurs des premier et second paramètres définissant un point de fonctionnement de détection du circuit numérique ;

c) déterminer, pour ladite valeur du premier paramètre, une seconde valeur du second paramètre au-delà de laquelle le circuit numérique est en dysfonctionnement ;

d) calculer, pour le point de fonctionnement de détection, une marge de correction égale à la différence entre les première et seconde valeurs du second paramètre.

Dans un mode de mise en oeuvre préférentiel du procédé de calibration, les étapes a) à d) du procédé de calibration sont mises en oeuvre pour une pluralité de circuits témoin ayant une structure identique au circuit numérique, pour une même valeur donnée du premier paramètre, de sorte à obtenir plusieurs marges de correction relatives au capteur, et comprenant en outre une étape de détermination d'une marge de correction optimale associé à la valeur du premier paramètre des points de fonctionnement de détection à partir des marges de correction relatives au capteur.

La marge de correction optimale peut être une moyenne arithmétique des marges de correction relatives au capteur ou la plus faible des marges de correction relatives au capteur.

Selon un développement du procédé de calibration, le second paramètre est la fréquence du signal d'horloge et chaque marge de correction est une marge en fréquence.

Selon un autre développement du procédé de calibration, le second paramètre est la période du signal d'horloge et chaque marge de correction est une marge en temps.

Selon un autre développement du procédé de calibration, le second paramètre est choisi parmi la tension d'alimentation et la tension de polarisation du circuit numérique et chaque marge de correction est une marge en tension.

De préférence, la seconde valeur du second paramètre est obtenue en activant un chemin conducteur de données critique et en modifiant progressivement le second paramètre jusqu'à provoquer une violation temporelle du signal de données reçu par l'élément séquentiel disposé sur le chemin critique, par rapport à un front actif du signal d'horloge.

Les étapes a) à d) sont avantageusement mises en oeuvre pour plusieurs valeurs du premier paramètre.

Le procédé de détermination et le procédé de calibration selon l'invention peuvent également présenter une ou plusieurs des caractéristiques ci-dessous, considérées individuellement ou selon toutes les combinaisons techniquement possibles :

- la fenêtre de détection est localisée avant un front actif du signal d'horloge ;
- la fenêtre de détection vaut entre 10 % et 50 % d'une période du signal d'horloge ;
- l'un des premier et second paramètres est choisi parmi la fréquence et la période du signal d'horloge et dans lequel l'autre des premier et second paramètres est choisi parmi la tension d'alimentation et la tension de polarisation du circuit numérique.

Un autre aspect de l'invention concerne un circuit électronique numérique comprenant :

- une pluralité d'éléments séquentiels ;
- des chemins conducteurs de données entre les éléments séquentiels, au moins un des chemins conducteurs de données étant critique en termes de délai de propagation des données ;
- un arbre d'horloge délivrant un premier signal d'horloge pour cadencer les éléments séquentiels ;
- un capteur de fautes temporelles de type préventif couplé à l'un des éléments séquentiels, recevant en entrée un signal de données arrivant sur l'élément séquentiel et configuré pour détecter, pendant une fenêtre de détection une transition du signal de données ;
- des moyens de réglage d'au moins un premier et un second de fonctionnement du circuit numérique ;
- un contrôleur configuré pour mettre en oeuvre, lors d'une phase de caractérisation, les étapes suivantes :

  e) activer un chemin conducteur de données jusqu'à l'élément séquentiel couplé au capteur ;

  f) déterminer, pour une valeur donnée du premier paramètre, une première valeur du second paramètre à partir de laquelle le capteur détecte une transition du signal de données pendant la fenêtre de détection, lesdites valeurs des premier et second paramètres définissant un point de fonctionnement de détection du circuit numérique ;

  g) déterminer un point de fonctionnement optimal associé au point de fonctionnement de détection, en ajoutant à la première valeur du second paramètre, une marge de correction prédéterminée en lien avec une valeur limite du deuxième paramètre qui entrainerait un dysfonctionnement du circuit numérique, pour la valeur donnée du premier paramètre, ladite marge de correction étant associée à la valeur donnée du premier paramètre du point de fonctionnement de détection.

Selon un développement du circuit électronique numérique, le contrôleur est en outre configuré pour mettre en oeuvre, lors d'une phase de calibration, les étapes suivantes :

a) activer un chemin conducteur de données jusqu'à l'élément séquentiel couplé au capteur ;
b) déterminer, pour une valeur donnée du premier paramètre, une première valeur du second paramètre à partir de laquelle le capteur détecte une transition du signal de données pendant la fenêtre de détection, lesdites valeurs des premier et second paramètres définissant un point de fonctionnement de détection du circuit numérique ;
c) déterminer, pour ladite valeur du premier paramètre, une seconde valeur du second paramètre au-delà de laquelle le circuit numérique est en dysfonctionnement ;
d) calculer, pour le point de fonctionnement de détection, une marge de correction égale à la différence entre les première et seconde valeurs du second paramètre.

Dans un mode de réalisation préférentiel, le circuit électronique numérique comporte :

- un dispositif de suivi en ligne du fonctionnement du circuit numérique, comprenant une chaîne de cellules de retard dont le délai de propagation varie de la même façon que le délai de propagation à travers le chemin critique et configuré pour délivrer une signature numérique représentative d'un rapport entre la période dudit signal d'horloge et le délai de propagation à travers un chemin critique ;
- un module de traitement configuré pour comparer la signature numérique issue du dispositif de suivi à une signature de référence, le résultat de la comparaison étant utilisée pour commander les moyens de réglage desdits paramètres de fonctionnement.

De préférence, le contrôleur est en outre configuré pour déterminer un ensemble de points de fonctionnement optimaux du circuit numérique, l'ensemble des points de fonctionnement optimaux constituant une courbe de fonctionnement optimal délimitant respectivement des zones de fonctionnement souhaité et non souhaité, et dans lequel ledit contrôleur est en outre configuré pour :

- identifier des tronçons de la courbe de fonctionnement optimal pour lesquels la signature numérique délivrée par le dispositif de suivi en ligne a une seule valeur ;
- enregistrer dans une mémoire couplée au module de traitement une zone de points de fonctionnement correspondant à chaque tronçon identifié et la signature de référence associée, la signature de référence associée étant fonction de la valeur de signature numérique délivrée par le dispositif de suivi en ligne pour les points de fonctionnement du tronçon identifié ;
- sélectionner, dans la mémoire, la signature de référence associée à la zone de points de fonctionnement incluant un point de fonctionnement courant du circuit numérique, la signature de référence sélectionnée étant utilisée par le module de traitement pour commander les moyens de réglage des paramètres de fonctionnement.

**BREVES DESCRIPTION DES FIGURES**

D'autres caractéristiques et avantages de l'invention ressortiront clairement de la description qui en est donnée ci-dessous, à titre indicatif et nullement limitatif, en référence aux figures annexées, parmi lesquelles :

- la figure 1, précédemment décrite, représente un premier dispositif de détection des violations temporelles selon l'art antérieur ;
- la figure 2, précédemment décrite, représente un deuxième dispositif de détection des violations temporelles selon l'art antérieur ;
- la figure 3 représente schématiquement une partie d'un circuit numérique dont on détermine le fonctionnement optimal grâce au procédé de caractérisation selon l'invention ;
- la figure 4A représente schématiquement un capteur de fautes temporelles pouvant être utilisé dans le procédé de caractérisation selon l'invention et la figure 4B représente des signaux de ce capteur ;
- les figures 5A à 5C sont des exemples de chronogramme illustrant l'application du capteur de fautes temporelles dans le procédé de caractérisation selon l'invention ;
- la figure 6 est un graphique de la fréquence F du signal d'horloge en fonction de la tension d'alimentation V du circuit, représentant plusieurs points de fonctionnement d'après un premier exemple de mise en oeuvre du procédé de caractérisation selon l'invention ;
- la figure 7 représente, en fonction de la tension d'alimentation V, la fréquence du signal d'horloge $F_d$ détectée grâce au capteur de la figure 4A et la fréquence maximale $F_{max}$ du circuit estimée d'après les informations de ce capteur ;
- la figure 8 est un graphique de la tension d'alimentation V du circuit en fonction de la fréquence F du signal d'horloge, représentant plusieurs points de fonctionnement d'après un deuxième exemple de mise en oeuvre du procédé de caractérisation selon l'invention ;

- la figure 9 est un graphique de la fréquence F du signal d'horloge en fonction de la tension d'alimentation V du circuit, représentant la détermination des marges de correction en fréquence $\Delta F_i$ d'après un procédé de calibration selon l'invention ;
- la figure 10 représente, en fonction de la tension d'alimentation V, la marge de correction en fréquence $\Delta F_i$ calculée à l'aide du procédé de calibration selon l'invention pour 6 circuits témoin de structure identique ;
- la figure 11 représente, en fonction de la tension d'alimentation V, l'erreur globale faite sur la détermination de la fréquence maximale du circuit de la figure 3, en comparaison des 6 circuits de la figure 10 ;
- la figure 12 représente schématiquement une autre partie d'un circuit électronique numérique dont le fonctionnement est optimisé ;
- la figure 13A représente schématiquement un mode de réalisation préférentiel d'un dispositif de suivi en ligne utilisé dans le circuit de la figure 12 et la figure 13B représente des signaux de ce dispositif ;
- la figure 14 représente des points de fonctionnement optimaux du circuit numérique, à un instant donné de la durée de vie du circuit, et les valeurs de référence associées d'un signal en sortie du dispositif de la figure 13A ; et
- la figure 15 représente des points de fonctionnement optimaux du circuit numérique, à un autre instant de la durée de vie du circuit, et les nouvelles valeurs de référence associées du signal en sortie du dispositif de la figure 13A.

Pour plus de clarté, les éléments identiques ou similaires sont repérés par des signes de références identiques sur l'ensemble des figures.

## DESCRIPTION DETAILLEE D'AU MOINS UN MODE DE REALISATION

De nombreux paramètres sont à prendre en considération pour vérifier que les contraintes temporelles dans un circuit numérique en logique synchrone sont respectées. La fréquence du signal d'horloge est, bien sûr, un critère important car les contraintes de temps d'établissement et de maintien des composants du circuit sont définies par rapport à un front actif du signal d'horloge. Toutefois, la tension d'alimentation, la tension de polarisation du substrat et la température jouent également un rôle dans le respect des contraintes temporelles, car ces paramètres vont influencer les délais de propagation des données dans le circuit.

On vise ici à déterminer les valeurs de deux de ces paramètres qui permettront de faire fonctionner le circuit numérique de façon optimale, en tenant compte de l'environnement dans lequel il est placé. Il s'agit, par exemple, de déterminer la fréquence maximale du signal d'horloge que le circuit peut tolérer, compte tenu de sa tension d'alimentation. On peut souhaiter au contraire déterminer la tension d'alimentation minimale acceptable par le circuit, à une fréquence de fonctionnement donnée, afin de minimiser sa consommation électrique.

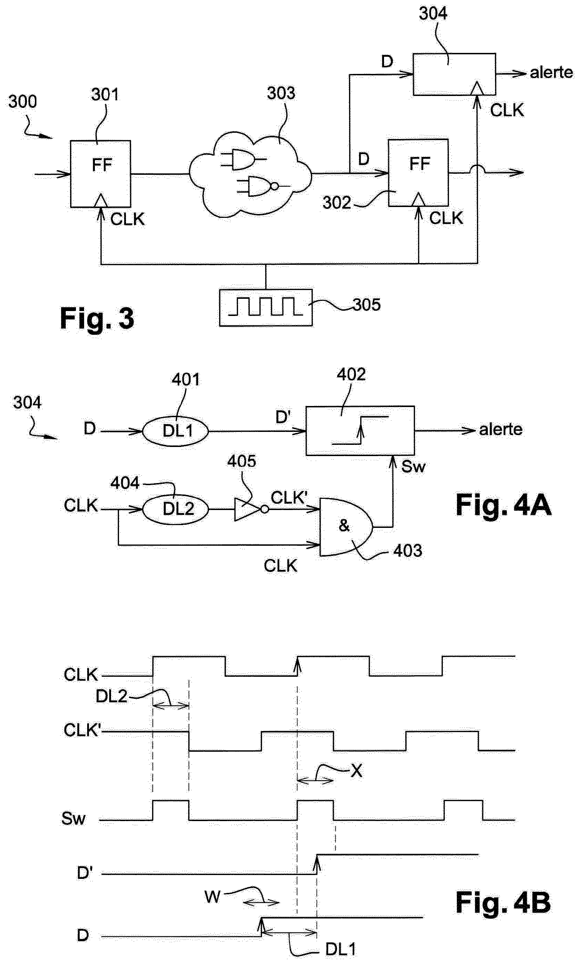

La figure 3 représente une partie d'un circuit numérique 300 dont on veut optimiser le fonctionnement, notamment en termes de vitesse de fonctionnement ou de consommation énergétique. Le circuit numérique est, à titre d'exemple, un microprocesseur capable d'effectuer une multitude d'opérations, telles que des additions.

Ce circuit 300 comprend une pluralité d'éléments séquentiels, de préférence de type bascule, dont au moins un élément séquentiel de départ 301 et un élément séquentiel de destination 302. Typiquement, chaque élément séquentiel de type bascule forme une partie d'un registre, qui sert à stocker temporairement une donnée numérique (1 bascule par bit de donnée). L'élément séquentiel de départ 301 est relié à l'élément séquentiel de destination 302 par un chemin de données 303, sur lequel circule un signal de données D. Le chemin de données 303 comporte classiquement des portes logiques, traversées par le signal de données D et agencées entre elles pour remplir une certaine fonction logique.

Le circuit comprend en outre un capteur de fautes temporelles 304 couplé à l'élément séquentiel de destination 302. Ce capteur 304 reçoit en entrée le signal de données D venant du chemin critique 303 et arrivant sur la bascule de destination 302. Les éléments séquentiels 301-302 et le capteur de fautes temporelles 304 sont cadencés par un signal d'horloge CLK provenant d'un arbre d'horloge 305. Ainsi, la bascule 302 et le capteur 304 partagent le même signal d'entrée D et le même signal d'horloge CLK.

Le capteur 304 est de type préventif, c'est-à-dire qu'il anticipe des fautes temporelles dans le circuit numérique. Son rôle est de détecter une transition du signal de données D pendant une fenêtre d'observation placée avant le front actif du signal d'horloge (i.e. le front qui déclenche les bascules). Dans le cas où un temps d'établissement doit être respecté en avant d'un front actif du signal d'horloge, il faudra bien entendu que la fenêtre d'observation débute avant ce temps d'établissement (« set-up time ») pour que le capteur permette d'anticiper les fautes temporelles. Comme cela est décrit en détail ci-après, l'avertissement fourni par le capteur permet de déterminer un point de fonctionnement optimal du circuit.

Le capteur 304 et la bascule de destination 302 peuvent ensemble former un dispositif de type « Canary Flip-Flop », tel que décrit précédemment en relation avec la figure 2. Le capteur 304 comporte alors une autre bascule, identique à la bascule 302, une cellule de délai en entrée de cette deuxième bascule et un système de comparaison des valeurs en sortie des deux bascules. La fenêtre de détection est dans ce cas définie par ses extrémités que sont les instants où chaque bascule échantillonne le signal de données (l'une des extrémités est le front actif du signal d'horloge, l'autre est située plus tôt dans le cycle d'horloge). Une transition de ce signal est détectée lorsque les valeurs aux deux instants (i.e. en sortie des deux bascules) diffèrent.

Dans un mode de réalisation préférentiel, le capteur de fautes temporelles 304 est un dispositif de surveillance de transitions, tel que celui décrit dans la demande WO2010/122036. Ce type de capteurs surveille l'activité du signal de données pendant toute une période, à la différence du dispositif « Canary Flip-Flop ».

La figure 4A est un schéma synoptique d'un mode de réalisation préférentiel du dispositif de surveillance 304, tandis que la figure 4B représente certains de ses signaux sous la forme de chronogrammes.

Le dispositif de surveillance 304 comporte une première cellule de retard 401 recevant en entrée le signal de données D. La cellule 401 introduit un retard DL1 dans le signal de données D. Par conséquent, le signal en sortie de la cellule 401, noté D' sur les figures 4A et 4B, est décalé d'une période de temps égale au retard DL1 par rapport au signal de données D (Fig.4B).

Le signal retardé D' est dirigé en entrée d'un détecteur de transition 402, qui observe l'activité du signal D' pendant une période de détection X du cycle d'horloge. Cette période de détection X démarre à compter d'un front actif du signal d'horloge CLK, (par exemple le front montant - Fig.4B). Elle correspond à un signal Sw généré à partir du signal d'horloge CLK et d'un signal CLK' inversé et retardé par rapport au signal d'horloge CLK. Le dispositif 304 comporte à cet effet une porte « ET » 403, dont les entrées correspondent aux signaux CLK et CLK' et dont la sortie forme le signal Sw. Le signal CLK' est dérivé du signal CLK grâce à une deuxième cellule de retard 404 et un inverseur 405 connectés en série.

De façon artificielle grâce au décalage DL1, le détecteur 402 observe, après le front actif du signal d'horloge, l'activité du signal de données D ayant cours pendant une fenêtre W précédant ce front d'horloge. En effet, lorsqu'une transition du signal D' est détectée pendant la période X, cela signifie qu'une transition du signal de données D a eu lieu un instant plus tôt, pendant la fenêtre W. Le retard DL1 introduit par la cellule 401 détermine la position de la fenêtre d'observation W dans le cycle d'horloge (car le décalage DL1 se retrouve entre la période X et la fenêtre W). Le retard DL2 introduit par la cellule 404 fixe la durée de la période de détection X, égale à la durée de la fenêtre d'observation W.

Contrairement aux techniques classiques de suivi en ligne, le capteur de fautes temporelles 304 de la figure 3 est ici configuré pour détecter une faute temporelle très tôt dans le cycle d'horloge. A cette fin, le capteur peut disposer d'une fenêtre de détection W placée juste avant le front actif du signal d'horloge et couvrant une grande partie du cycle d'horloge. Sa durée est, de préférence, comprise entre 10 % et 50 % d'un cycle d'horloge.

La fenêtre W peut aussi être courte (durée comprise entre 5 % et 10 % d'un cycle d'horloge) et placé bien avant le front montant d'horloge. Le début de cette fenêtre courte intervient au même instant que le celui de la fenêtre longue, à 10%-50% de la période d'horloge en avant du front montant. Cela équivaut à réduire le délai DL2 en gardant le même délai DL1.

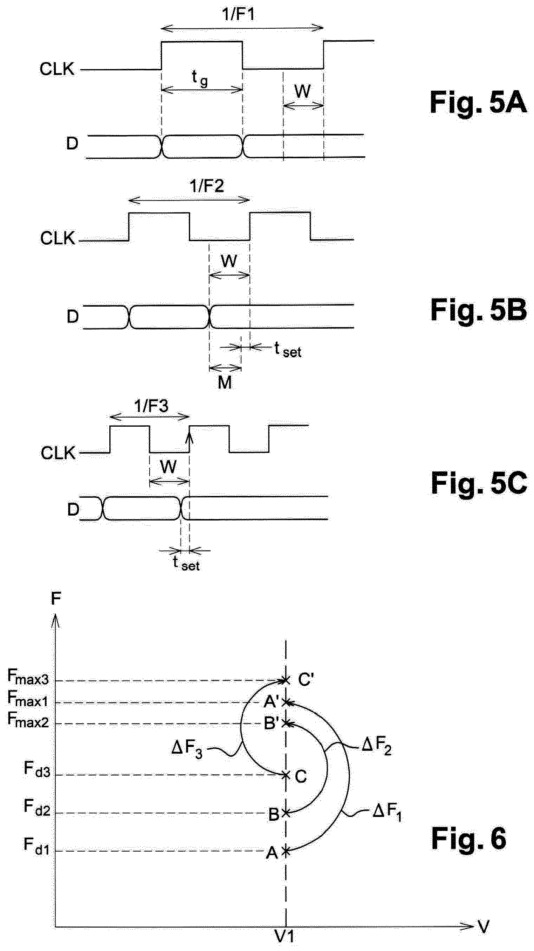

Les figures 5A à 5C sont des exemples de chronogramme qui illustrent cette utilisation particulière du capteur de fautes temporelles 304.

Les chronogrammes de la figure 5A représentent un signal d'horloge CLK à une fréquence d'horloge F1 et un signal de données D en entrée de la bascule de destination. Le temps de propagation $t_G$ du signal de données D, appelé également « temps d'arrivée » (à l'entrée de la bascule), démarre au premier front montant du signal d'horloge CLK et prend fin avant la fenêtre de détection W du capteur (elle-même placée juste avant le front montant suivant). Comme le capteur ne voit aucune transition du signal D pendant la fenêtre W, celui-ci n'émet aucune alerte.

Sur la figure 5B, le signal d'horloge a une fréquence F2 plus élevée que la fréquence F1. La donnée D se stabilise à l'entrée de la fenêtre de détection W. Dans ce cas, le capteur 304 voit une transition du signal de données D et indique qu'une faute temporelle s'est produite. Toutefois, cette faute n'a qu'un caractère informatif, elle n'est pas synonyme d'une erreur de la bascule, car le temps d'établissement $t_{set}$ de la bascule n'a pas été violé. En effet, il existe encore une certaine marge M entre le début de la fenêtre de détection W et le premier instant où le temps d'établissement $t_{set}$ est violé. La figure 5B représente donc un point de fonctionnement non optimisé si on considère uniquement la bascule associée au capteur, car la marge de détection M pourrait être diminuée.

Néanmoins, si le capteur 304 n'est pas associé au chemin de données le plus critique du circuit, il est souhaitable d'avoir une marge M au moins égale à la différence des temps de propagation entre le chemin critique du circuit et le chemin de données associé au capteur. Ainsi, ce capteur permet d'estimer la probabilité d'erreur sur un autre chemin le plus critique.

A la figure 5C, la fréquence F3 du signal d'horloge CLK est telle que le temps de propagation du signal de données D prend fin à la limite de violation du temps d'établissement $t_{set}$. Autrement dit, la marge M de la figure 5B n'existe plus et une fréquence d'horloge supérieure provoquerait une violation du temps d'établissement $t_{set}$ de la bascule associée au capteur 304 (car le front actif du signal d'horloge CLK se trouverait en regard de l'état instable du signal D). La figure 5C représente donc un point de fonctionnement optimal pour la bascule associée au capteur 304. La fréquence F3 correspond sensiblement à la fréquence maximale que peut tolérer le circuit si le chemin de données associé à la bascule est le chemin le plus critique.

On voit, d'après les figures 5A à 5C, que le fait d'utiliser une large fenêtre de détection permet de relever des « fautes temporelles » à une fréquence d'horloge (F2) bien plus faible que la fréquence d'horloge maximale F3. A l'inverse, dans les solutions de l'art antérieur, la fenêtre de détection du capteur est restreinte et localisée uniquement autour du front actif, afin de s'approcher autant que possible de la fréquence maximale et ne vérifier que les violations du temps d'établissement $t_{set}$ (et/ou du temps de maintien). Une fenêtre longue provoquerait dans le dispositif « Canary flip-flop » de la figure 2 une détection très précoce et résulterait (selon l'approche « DFS » classique) en une fréquence de fonctionnement éloignée de la fréquence maximale.

Partant de ce principe, un mode de mise en oeuvre du procédé de caractérisation selon l'invention consiste à détecter un premier point de fonctionnement du circuit numérique, éloigné du point de fonctionnement optimal (par exemple, ayant une fréquence d'horloge F2 plus faible que la fréquence maximale F3 autorisée), puis à corriger ce point de fonctionnement détecté, connaissant le décalage (F3-F2) qui le sépare du point de fonctionnement optimal. Comme cela est décrit ci-après en relation avec le procédé de calibration, le décalage a été préalablement calculé après recherche de la limite de fonctionnement du circuit numérique, autrement dit après recherche de la fréquence F3 qui engendre une faute sur un chemin critique du circuit.

Chaque point de fonctionnement est défini par au moins deux paramètres de fonctionnement. De préférence, l'un des deux paramètres est la fréquence du signal d'horloge. L'autre paramètre (ou les autres paramètres, si plus de deux) est avantageusement choisi parmi la tension d'alimentation du circuit numérique, la tension de polarisation du substrat qui sert de support au circuit numérique et la température de fonctionnement. Pour les besoins de cette caractérisation, le circuit numérique comporte donc des moyens pour faire varier ces paramètres. A titre d'exemple, la fréquence d'horloge est réglée au moyen d'une boucle à verrouillage de phase (PLL, « Phase-locked loop ») ou de fréquence (FLL, « Frequency-locked loop »). Les tensions d'alimentation et de polarisation peuvent être réglées par l'intermédiaire de convertisseurs DC-DC.

La prise en compte de la température de fonctionnement ajoute un degré supplémentaire dans la caractérisation du circuit (chaque point de fonctionnement est alors défini par trois valeurs de paramètres). La fréquence d'horloge, la tension d'alimentation et/ou la tension de polarisation peuvent alors être déterminées pour plusieurs valeurs de température. On peut ainsi obtenir des informations sur le comportement du circuit en température. Néanmoins, à moins de disposer de moyens de chauffage ou de refroidissement du circuit, il n'est pas possible de commander/réguler la température au moyen d'un actionneur dédié. La température sera donc le plus souvent un des paramètres environnementaux que l'on subit et auquel il faut s'adapter.

Considérons dans un premier exemple de mise en oeuvre du procédé de caractérisation que l'on veuille déterminer la fréquence d'horloge maximale pour une valeur donnée de la tension d'alimentation. Cet exemple est décrit ci-dessous en relation avec la figure 6 et la valeur de la tension est notée V1.

Lors d'une première étape de ce procédé de caractérisation, on détermine la valeur $F_{d1}$ de la fréquence d'horloge à partir de laquelle le capteur détecte une faute temporelle, c'est-à-dire une transition du signal de données pendant la fenêtre de détection. Pour cela, la fréquence peut être augmentée progressivement au moyen de la boucle à verrouillage de phase, jusqu'à ce que la transition du signal de données D « entre » dans la fenêtre de détection W (cf. Fig.5B).

Le chemin de données jusqu'à la bascule couplée au capteur nécessite d'être activé pour que le capteur puisse (éventuellement) détecter une transition. Une opération, dont on sait qu'elle produit un signal parcourant le chemin de données associé au capteur, est fournie au circuit numérique. Cette opération, par exemple une opération d'addition avec retenue, peut avoir été déterminée au préalable lors du choix de l'emplacement du capteur (une certaine opération est exécutée par le circuit et le capteur est disposé dans le chemin que l'opération active).

Cette opération n'est pas nécessairement l'opération la plus critique en termes de délai de propagation (i.e de temps d'arrivée). En effet, à la différence des solutions de l'art antérieur, le capteur de fautes temporelles 304 peut être ici couplé à une bascule se situant dans un chemin de données moins critique, car la fenêtre est suffisamment en avance du front pour détecter la transition du signal de données (la donnée circulant sur un chemin non-critique est stable avant celle circulant sur un chemin critique). Or, il est préférable d'ajouter des capteurs sur des chemins peu critiques, plutôt que sur les chemins les plus critiques en délai, car ainsi ils affecteront les performances temporelles du circuit dans une moindre mesure.

A l'issue de cette première étape, un premier point de fonctionnement A, défini par la valeur V1 de la tension d'alimentation et la valeur $F_{d1}$ de fréquence d'horloge est obtenu (Fig.6).

Comme indiqué précédemment, ce premier point de fonctionnement A n'est pas optimal, car il existe une marge superflue importante dû au fait que la fenêtre de détection est grande. Ainsi, lors d'une deuxième étape du procédé de caractérisation, le point de fonctionnement A est corrigé, en ajoutant à la fréquence $F_{d1}$ une marge de fréquence prédéterminée $\Delta F_1$. Cette marge $\Delta F_1$ est inférieure ou égale (selon le degré de « criticité » du chemin couplé au capteur) à l'écart M qui sépare le début de la fenêtre de détection (Fig.5B) de l'instant où le temps d'établissement de la bascule risque d'être violé (Fig.5C). Le point corrigé A' conserve la même valeur de tension (V1), mais dispose d'une valeur de

fréquence augmentée $F_{max1}$ ($F_{max1}$ = $F_{d1}$ + $\Delta F_1$), d'un facteur $\Delta F1$ qui est représentatif de la différence entre les temps de propagation du chemin le plus critique et du chemin de données associé au capteur.

De préférence, le circuit numérique comprend une pluralité de capteurs de fautes temporelles, couplés chacun à un des éléments séquentiels de type bascule du circuit, et les étapes précédentes sont mises en oeuvre pour chacun de ces capteurs. Comme ces capteurs sont couplés à des bascules de destination différentes, et donc associés à des chemins de données distincts, ils ne réagissent pas aux mêmes stimuli (i.e. les opérations que traitent le circuit et qui activent les chemins de données). On fera en sorte d'appliquer un ensemble de stimuli permettant d'activer l'ensemble des chemins de données associées à des capteurs. Cet ensemble de stimuli est répété pour chaque fréquence considérée. Les chemins de données associés aux capteurs étant différents et les fenêtres de détection potentiellement différentes pour chaque capteur, il est fort probable que les capteurs commencent à détecter une « erreur » à des fréquences différentes. Les fréquences de détection des transitions peuvent donc varier.

Une pluralité de points de fonctionnement A, B, C est alors obtenue. Chaque point correspond à la mesure d'une fréquence à laquelle se manifeste l'un des capteurs. Ces points ont en commun la valeur V1 de la tension d'alimentation. En effet, au moment de caractériser le circuit, les capteurs sont activés à tour de rôle mais la tension d'alimentation V ne varie pas.

Le circuit compte par exemple 128 capteurs. Toutefois, sur le graphe de la figure 6, seulement trois points A, B et C (correspondant aux relevés de 3 capteurs) sont représentés dans un souci de clarté. Ils ont respectivement pour ordonnées les fréquences $F_{d1}$, $F_{d2}$, $F_{d3}$.

Les points de fonctionnement B et C sont corrigés en leur ajoutant une marge de fréquence, comme cela est décrit ci-dessus en relation avec le premier point A. Les marges de correction des points B et C sont notées respectivement $\Delta F_2$ et $\Delta F_3$ et les points corrigés correspondants sont désignés B' et C' sur la figure 6.

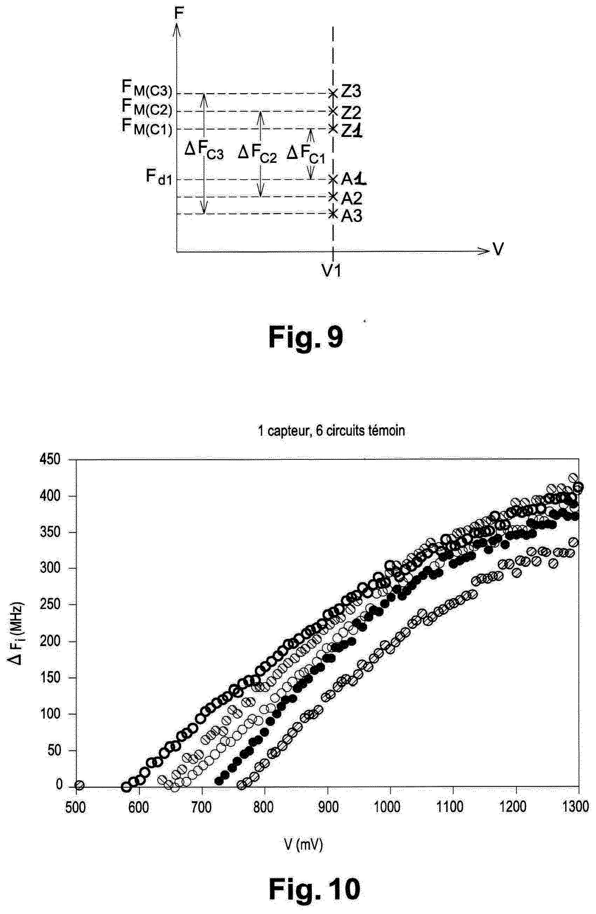

Les valeurs de marge de correction $AF_1$ à $\Delta F_3$ sont telles que les points corrigés A', B' et C' issus de différents capteurs sont, en pratique, très proches les uns des autres (globalement, plus la fréquence de détection $F_d$ est basse, plus la marge correspondante $\Delta F$ sera importante). La manière dont sont calculées ces marges de correction $\Delta F_1$ à $\Delta F_3$ sera décrite plus loin, en relation avec les figures 9 et 10.

Après avoir obtenu plusieurs points de fonctionnement corrigés A', B' et C', comme représenté sur la figure 6, le procédé de caractérisation comporte une étape de détermination d'un unique point de fonctionnement optimal du circuit à partir de ces points de fonctionnement corrigés. Ce point de fonctionnement optimal est, d'une certaine façon, une synthèse des indications données par les différents capteurs sur le comportement en fréquence du circuit.

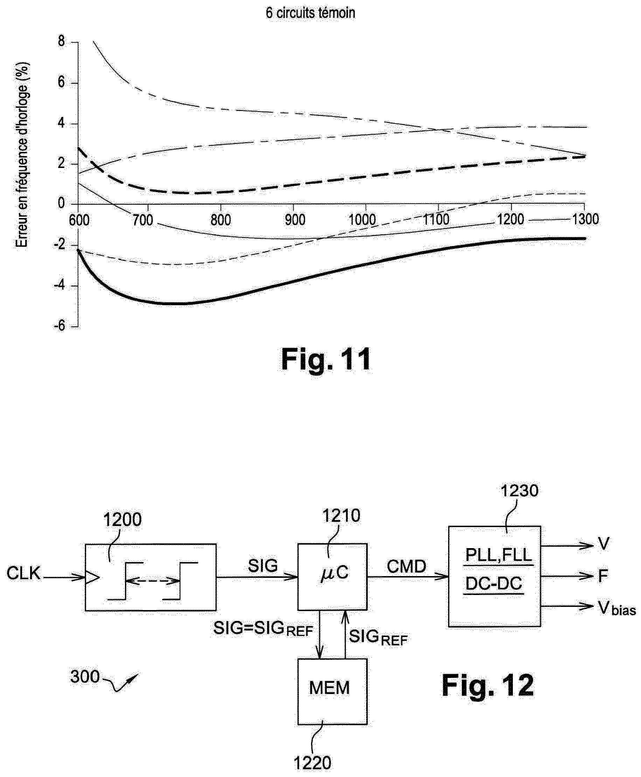

Dans un mode de réalisation préférentiel, ce point de fonctionnement optimal est défini par la valeur V1 de la tension d'alimentation et par une moyenne arithmétique des fréquences corrigées $F_{max1}$ à $F_{max3}$. Cette moyenne permet de compenser les erreurs d'estimation faites sur chacune des marges de correction $\Delta F_1$ à $\Delta F_3$. Autrement dit, la fréquence optimale peut être supérieure aux valeurs de fréquence corrigées d'un ou plusieurs capteurs. En faisant fonctionner le circuit à une telle fréquence moyenne, des violations du temps d'établissement risquent de se produire en entrée des bascules associées aux chemins les plus critiques. Afin d'y remédier, une marge de sécurité soigneusement calibrée est prise en compte. Cette marge de sécurité est décrite en relation avec la figure 11.

Alternativement, le point de fonctionnement optimal est défini par la valeur V1 de la tension d'alimentation et la plus faible des valeurs de fréquence corrigées $F_{max1}$ à $F_{max3}$, soit le point B' dans l'exemple de la figure 6. Dans cette variante de réalisation, la fréquence de fonctionnement est limitée au « pire cas » mais réduit considérablement le risque de violation du temps d'établissement des bascules associées aux chemins les plus critiques.

De façon plus générale, le point de fonctionnement optimal peut être dérivé des points de fonctionnement corrigés, en appliquant diverses opérations mathématiques sur les fréquences $F_{max1}$ à $F_{max3}$, comme une moyenne pondérée (les poids étant, de préférence, fonction du degré de criticité des chemins couplés aux capteurs).

Si l'on répète maintenant ces opérations pour différentes valeurs de la tension d'alimentation V, on peut établir une courbe caractéristique de la fréquence d'horloge $F_d$ à laquelle chaque capteur détecte une faute, en fonction de la tension d'alimentation V, et une autre courbe représentant la fréquence maximale $F_{max}$ du circuit en fonction de la tension V, à partir des courbes caractéristiques des différents capteurs.

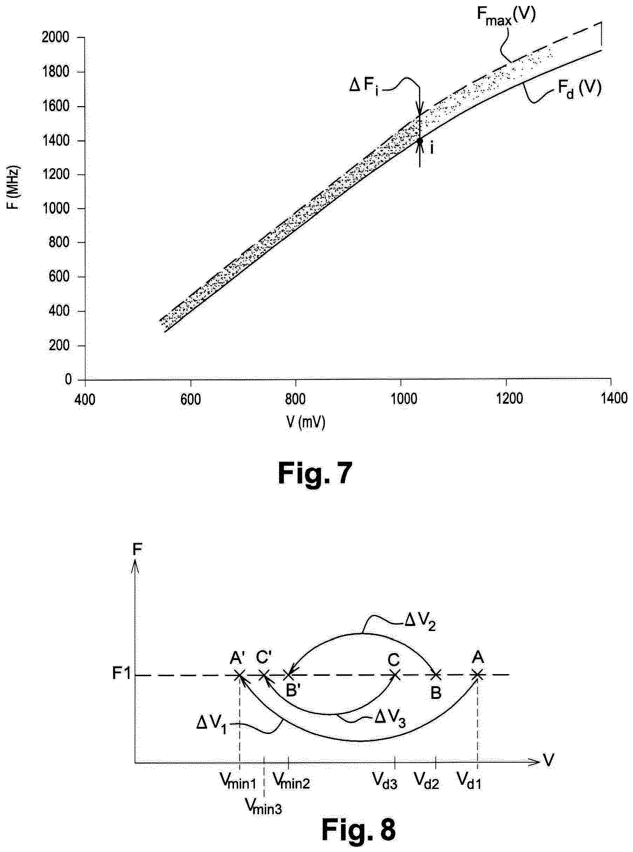

La figure 7 montre un exemple de courbe de fréquence $F_d(V)$ obtenue à l'aide d'un capteur de fautes temporelles (en trait plein) et un exemple de courbe de la fréquence maximale estimée du circuit $F_{max}(V)$, relative à ce capteur (en traits pointillés). La courbe $F_{max}(V)$ est obtenue, en appliquant à chaque point i de la courbe $F_d(V)$, une marge de correction en fréquence $\Delta F_i$ associée à ce point.

La marge de correction $\Delta F_i$ varie généralement en fonction du point de fonctionnement relevé par chaque capteur. Deux points relevés par deux capteurs différents, ayant la même tension mais des fréquences différentes (A et B par exemple), peuvent avoir des marges de correction ($\Delta F_1$ et $\Delta F_2$) différentes. Deux points relevés par un même capteur mais à des tensions différentes peuvent aussi avoir des marges de correction différentes.

Dans un deuxième exemple de mise en oeuvre du procédé de caractérisation représenté à la figure 8, on souhaite plutôt déterminer la tension minimale d'alimentation à fréquence d'horloge constante. La situation est donc l'inverse de celle décrite précédemment : la tension d'alimentation V est diminuée pas à pas et la fréquence est fixe, à une valeur F1.

En diminuant la tension d'alimentation, le temps de propagation du signal de données D en entrée de la bascule de destination se rallonge. Le principe de mesure est donc inchangé, car plutôt que de déplacer le front actif du signal d'horloge vers la gauche, c'est le temps de propagation $t_G$ qui se prolonge vers la droite, jusqu'à la fenêtre de détection W (Fig.5A-C).

Sur la figure 8, la tension d'alimentation V est diminuée jusqu'au point A où un premier capteur détecte une transition du signal de données en entrée de sa fenêtre de détection. Cette première valeur de tension pour laquelle le capteur détecte une faute est notée $V_{d1}$. On sait cependant que la tension d'alimentation pourrait être diminuée davantage, pour tenir compte de la marge M prise pour la détection (Fig.5B). Ainsi, une marge de correction $\Delta V_1$ est appliquée pour déplacer le point de fonctionnement A à une tension plus basse $V_{min1}$. A' désigne le point de fonctionnement ainsi corrigé. Cette marge en tension $\Delta V_1$ est, par convention, choisie négative et ajoutée à la valeur $V_{d1}$ ($V_{min1} = V_{d1} + \Delta V_1$).

Comme précédent, il est possible de prévoir plusieurs capteurs de fautes temporelles dans le circuit et ainsi obtenir plusieurs points de fonctionnement corrigés A', B' et C', chacun étant relatif à un capteur et caractérisé par une valeur minimale de la tension d'alimentation, respectivement $V_{min1}$, $V_{min2}$ et $V_{min3}$. Chaque valeur minimale $V_{min1}$, $V_{min2}$ et $V_{min3}$ est déterminée à partir d'une valeur de détection de la tension, respectivement $V_{d1}$, $V_{d2}$ et $V_{d3}$, et d'une marge en tension associée à chaque capteur qui peut être fonction de cette tension de détection, respectivement $\Delta V_1$, $\Delta V_2$ et $\Delta V_3$.

Un point de fonctionnement optimal peut alors être déduit des points de fonctionnement corrigés, par exemple en calculant la moyenne de ces valeurs minimales de tension ou en prenant, par précaution, la plus forte d'entre elles.

De même, on pourra établir une courbe caractéristique de la tension minimale d'alimentation du circuit numérique en fonction de la fréquence d'horloge, en obtenant du ou des capteurs une pluralité de points de fonctionnement corrigés à des valeurs de fréquence différentes.

Dans les exemples du procédé de caractérisation ci-dessus, on remarque que la détermination d'un point de fonctionnement (par exemple A) est réalisée en faisant varier un paramètre choisi parmi la fréquence d'horloge F et la tension d'alimentation V.

Une façon préférentielle de déterminer, pour chaque point de fonctionnement, la marge de correction (en fréquence ou en tension) va maintenant être décrite en relation avec les figures 9 et 10.

La détermination des marges de correction fait ici l'objet d'un procédé de calibration du circuit numérique. Ce procédé de calibration utilise les mêmes moyens que ceux décrits précédemment : le circuit numérique de la figure 3 muni d'au moins un capteur de fautes temporelles 304 couplé à l'un des éléments séquentiels 302.

La figure 9 représente un exemple de calcul d'une marge de correction en fréquence.

La première étape du procédé de calibration est identique à la première étape du procédé de caractérisation. Elle consiste à mesurer, pour une valeur de la tension d'alimentation V1, la valeur $F_{d1}$ de la fréquence d'horloge, à partir de laquelle le capteur voit une transition du signal de données. Un premier point de fonctionnement A1, représentatif du début de la fenêtre de détection (Fig.5B), est ainsi obtenu.

Lors d'une deuxième étape, le circuit numérique est caractérisé pour déterminer sa fréquence maximale absolue $F_{M(c1)}$. La valeur de la tension d'alimentation V1 n'est pas modifiée lors de cette caractérisation. La fréquence maximale $F_{M(c1)}$ est qualifiée de « absolue » car elle n'est pas relative à un capteur de fautes temporelles à la différence de la fréquence maximale $F_{max1}$ déterminée lors du procédé de caractérisation (qui se base sur la fréquence détectée $F_{d1}$ - Fig.6). Il s'agit de la fréquence au-delà de laquelle le circuit est en dysfonctionnement.

La caractérisation de la fréquence maximale absolue $F_{M(c1)}$ peut être réalisée par la technique du « sur-cadençage ». Elle consiste à pousser la fréquence du circuit jusqu'à provoquer sa défaillance. En pratique, une multitude d'opérations est fournie au circuit numérique de façon à activer le plus critique des chemins de données (qui n'est pas nécessairement équipé d'un capteur). L'activation de ce chemin va, passé une certaine fréquence, provoquer une violation temporelle d'un élément séquentiel du circuit disposé dans ce chemin et mettre le circuit en état d'erreur. Par exemple, le temps d'établissement ou le temps de maintien du signal de données en entrée de cet élément séquentiel sera violé.

Sur la figure 9, la limite de fonctionnement du circuit correspond à un point de fonctionnement Z1 dont les cordonnées tension-fréquence sont les valeurs V1 et $F_{M(c1)}$.

Dans ce procédé de calibration, la marge de fréquence est considérée comme équivalent à la différence entre la fréquence maximale absolue $F_{M(c1)}$ du circuit et la valeur de fréquence $F_{d1}$ relative au capteur.

Ainsi, lors d'une troisième étape du procédé, une marge de correction en fréquence $\Delta F_{C1}$ relative au point de fonctionnement A1 est déterminée, en calculant la différence entre les valeurs $F_{M(c1)}$ et $F_{d1}$ déterminées lors des deux étapes précédentes.

Bien sûr, la fréquence de détection $F_{d1}$ et la fréquence maximale absolue $F_{M(c1)}$ peuvent être mesurées pour différentes valeurs de la tension d'alimentation V, et pas seulement la valeur V1 ci-dessus, afin d'obtenir les marges en fréquence $\Delta F_{C1}$ pour tous les points de fonctionnement relatif au capteur, c'est-à-dire pour tous les points de la courbe $F_d(V)$ (Fig.7). La marge ainsi calculée pour chaque valeur de la tension d'alimentation peut d'ailleurs être exprimée sous la forme d'une équation $\Delta F_{C1}(V)$.

En outre, pour affiner le calcul des marges en fréquence, les différentes étapes du procédé de calibration peuvent être mises en oeuvre pour plusieurs unités C1 à C3 du circuit numérique. Des circuits témoin, ayant une structure identique au circuit numérique de la figure 3, sont utilisés à cet effet. Ils comprennent notamment un ou plusieurs capteurs de fautes disposés aux mêmes emplacements que celui ou ceux du circuit numérique de la figure 3.

Chaque circuit témoin est caractérisé pour déterminer sa fréquence maximale absolue et la fréquence à laquelle le même capteur détecte une faute. Ces fréquences peuvent varier légèrement d'un circuit témoin à l'autre, à cause notamment de la variabilité du procédé de fabrication de ces circuits. Sur la figure 9, on a reporté (à la valeur V1 de la tension d'alimentation) la fréquence maximale absolue de deux de ces circuits témoin (circuits C2-C3), en plus de la fréquence $F_{M(c1)}$ calculée précédemment (pour le circuit C1). Ces fréquences sont notées $F_{M(c2)}$ et $F_{M(c3)}$, et correspondent aux points Z2 et Z3. De même, on a reporté le point de détection du capteur dans les deux circuits témoin supplémentaires : A2 et A3.

Enfin, pour chaque circuit témoin, la différence entre la fréquence maximale absolue et la valeur de fréquence détectée grâce au capteur est calculée. Ainsi, des deuxième et troisième valeurs de marge en fréquence $\Delta F_{C2}$ et $\Delta F_{C3}$, relatives au même capteur et à la valeur V1 de la tension d'alimentation, sont obtenues.

Une marge de correction optimale $\Delta F$ du point de fonctionnement A d'un capteur est avantageusement déterminée à partir des différentes marges de correction $\Delta F_{C1}$ à $\Delta F_{C3}$, relatives au capteur. Dans un mode de mise en oeuvre préférentiel, cette marge optimale est une moyenne arithmétique des marges de correction $\Delta F_{C1}$ à $\Delta F_{C3}$ précédemment calculées. Alternativement, la marge de correction optimale peut être la plus pessimiste des valeurs $\Delta F_{C1}$ à $\Delta F_{C3}$, c'est-à-dire la plus faible d'entre elles, de sorte que la marge ainsi sélectionnée convienne quel que soit le circuit numérique utilisé. Plus le nombre de circuits témoin est important, plus la détermination de la marge de correction est précise.

La figure 10 représente, en fonction de la tension d'alimentation V, la marge en fréquence $\Delta F_i$ relative à un capteur du circuit numérique, calculée en référence à 6 circuits témoin d'après le procédé de calibration. On constate que les 6 courbes ont sensiblement la même forme et que des faibles écarts séparent les différentes marges relatives au même capteur. Ces écarts sont représentatifs des variations de la fréquence maximale absolue et de la fréquence de détection parmi les 6 circuits témoin, notamment dues aux variations de procédé de fabrication.

Le calcul d'une marge en tension peut être réalisé de façon similaire, en mesurant (pour une fréquence d'horloge fixée) une valeur $V_{d1}$ de la tension d'alimentation qui permet de détecter une transition et en mesurant la tension minimale absolue $V_{m(c1)}$ du circuit numérique, c'est-à-dire la tension d'alimentation en dessous de laquelle des violations temporelles causent une erreur du circuit. Puis, la marge en tension $\Delta V_{c1}$, égale à la différence entre ces deux valeurs, est calculée.

Comme précédemment, plusieurs circuits témoin peuvent être caractérisés afin de déterminer plusieurs valeurs de la tension minimale absolue et plusieurs valeurs de marge relatives à un même point de fonctionnement. Les différentes marges sont ensuite moyennées ou la plus pessimiste d'entre elles (i.e. la plus faible) est sélectionnée.

La calibration du circuit, pendant laquelle on détermine les marges de correction, est réalisée préalablement à l'utilisation du circuit, par exemple à sa sortie d'usine. Elle est longue à mettre en oeuvre, car elle requiert de tester en profondeur le circuit (pour déterminer sa limite de fonctionnement). Par contre, elle permet d'obtenir, en une seule fois pour chaque type de circuit numérique, les marges de correction en fréquence, ou en tension, à appliquer pour un capteur donné.

Lorsqu'on souhaite ultérieurement optimiser le fonctionnement du circuit lors de son utilisation pour définir des points de la courbe de fréquence maximale $F_{max}(V)$, il suffit en pratique à l'aide des capteurs de fautes temporelles de relever un certain nombre de points de fonctionnement de détection et de leur appliquer la marge de correction correspondante préalablement calculée ou facilement calculable sur la base des éléments obtenus lors du procédé de fabrication. Le circuit n'est utilisé que temporairement à cette fin de mise à jour de la caractéristique $F_{max}(V)$, avec un nombre réduit d'opérations. Ainsi, grâce au fait que les marges de correction ont été prédéterminées ou qu'un moyen de calcul de celles-ci a été prédéterminé lors du procédé de calibration, le procédé de caractérisation est un processus très court, qui peut être mise en oeuvre plusieurs fois dans le temps, notamment pour prendre en compte le vieillissement du circuit ou de nouvelles conditions environnementales. On notera que le procédé de caractérisation peut être rendu transparent pour l'utilisateur, par exemple dans le cas d'un circuit de type SOC comprenant plusieurs unités de traitement et pour lequel une unité de traitement est momentanément inutilisée. En outre, cette transparence est également possible si l'activité courante du circuit permet d'activer le ou les chemins de données reliés aux capteurs. Dans la mesure où les capteurs sont de type préventif, il est possible de faire varier momentanément les paramètres de fonctionnement (Vdd, F) (si le système général de contrôle du circuit l'autorise) pour les besoins d'exécution du procédé de caractérisation, sans mettre en défaut le circuit.

Le circuit électronique numérique comprend des moyens pour mettre en oeuvre le procédé de caractérisation visant à déterminer au moins un point de fonctionnement optimal ($V_{min}$ ; $F_{max}$) présent pour le circuit, à un instant donné. Il comprend, de préférence :

- un dispositif de mesure, à une valeur V1 de la tension d'alimentation (respectivement de la fréquence; F1), d'une valeur $F_{d1}$ de la fréquence (respectivement de la tension ; $V_{d1}$) à partir de laquelle le capteur détecte une transition du signal de données pendant la fenêtre de détection ;

- un dispositif calculateur configuré pour ajouter à l'une des valeurs de la tension V1 ou de la fréquence $F_{d1}$ (respectivement F1 ou $V_{d1}$) une marge de correction prédéterminée, qui est fonction du point de fonctionnement de détection (V1 ; $F_{d1}$) (ou respectivement ($V_{d1}$, F1)) et obtenir un point de fonctionnement optimal (V1, $F_{max}$(V1)) (ou respectivement ($V_{max}$(F1), F1)).

La marge de correction prédéterminée devant être ajoutée par le calculateur correspond à la marge de correction optimale $\Delta F$ (respectivement $\Delta V$) associée au point de détection considéré (et notamment à la valeur de tension V1 de ce point - respectivement la valeur de fréquence F1 de ce point) qui a été préalablement déterminée lors du procédé de calibration. Autrement dit, cette marge de correction prédéterminée correspond à la différence entre la valeur $F_{d1}$ de la fréquence (respectivement de la tension $V_{d1}$) et une valeur de fréquence absolue $F_M$ (respectivement de la tension absolue $V_M$) au-delà de laquelle le circuit numérique est en dysfonctionnement.

On notera qu'idéalement, il faudrait mettre en oeuvre le procédé de calibration sur chaque circuit afin de déterminer, pour chaque capteur du circuit, la marge de correction optimale $\Delta F$ (respectivement $\Delta V$) associée à un point de détection du capteur présentant une tension V donnée (respectivement une fréquence F donnée). Néanmoins, en pratique, il peut s'avérer impossible pour des raisons matérielles ou financières de mettre en oeuvre le procédé de calibration sur chaque circuit. On procède alors à une sélection d'un ensemble de circuits témoin, présentant de préférence des valeurs de paramètres technologiques dispersées représentatives des variations de procédé de fabrication. On réalise ensuite pour cet ensemble de circuits le procédé de calibration tel que décrit ci-dessus en relation avec la figure 9 et on détermine une correction optimale $\Delta F$ (respectivement $\Delta V$) en fonction de l'ensemble des corrections $\Delta F_{ci}$ (respectivement $\Delta V_{ci}$) obtenues pour ces circuits témoin.

La marge de correction associée à chaque point de fonctionnement de détection, ou de préférence associé à une valeur d'un paramètre de ce point de fonctionnement de détection, peut par exemple être enregistrée dans une mémoire du circuit numérique. Après avoir mesuré un point de fonctionnement de détection à l'aide d'un capteur lors du procédé de caractérisation, le dispositif calculateur du circuit numérique chargé d'appliquer ces marges accède à la mémoire et peut dès lors corriger ce point de fonctionnement détecté en un point de fonctionnement corrigé.

Selon une variante de réalisation, il est possible de mémoriser non pas des valeurs de marge de correction, mais une fonction permettant de les calculer connaissant un point de fonctionnement de détection. Dans ce cas, il faudra calculer la marge de correction préalablement au calcul d'un point de fonctionnement corrigé (V1, $F_{max}$(V1)) (ou respectivement ($V_{max}$(F1), F1)).

Par exemple, la fonction $\Delta F(V1, F_d)$ donnant la marge de correction en fréquence des points de fonctionnement de détection peut être obtenue par régression de différentes courbes, chaque courbe représentant la marge de correction d'un exemplaire du circuit numérique en fonction de la fréquence détectée par le capteur (soit des courbes comme sur la figure 10, sauf qu'en abscisses figure la fréquence détectée $F_d$ plutôt que la tension d'alimentation V). La régression permet d'obtenir une seule courbe ayant une équation de la forme :

$$\Delta F(V1, F_d) = A(V1). F_d(V1) + B(V1)$$

où A et B sont des fonctions de la tension d'alimentation V.

La figure 11 représente, en fonction de la tension d'alimentation V, l'erreur commise sur la détermination de la fréquence d'horloge maximale $F_{max}$ du circuit conformément au premier exemple du procédé de caractérisation, par rapport à la fréquence maximale absolue des circuits témoin. Cette figure représente donc 6 courbes, chacune correspondant à la différence entre la fréquence maximale $F_{max}$(V) déterminée grâce au(x) capteur(s) de fautes temporelles et la fréquence maximale absolue d'un circuit témoin. On peut ainsi vérifier que le procédé de caractérisation est satisfaisant en termes de précision, autrement dit que les marges de correction calculées lors du procédé de calibration sont correctes.

Pour chaque courbe de la figure 11, i.e. chaque circuit témoin C1 à C6, l'erreur s'écrit :

$$Erreur_{(Cn)} (V) = F_{M(Cn)}(V) - F_{max(Cn)} (V)$$

où $F_{M(Cn)}$ est la fréquence maximale absolue du circuit n (n=1~6) et $F_{max(Cn)}$ est la fréquence maximale du circuit n, estimée en tenant compte d'une marge de correction optimale $\Delta F_{N\ circuits}$(V) recoupant les valeurs de marge de correction des 6 circuits témoins. Par ailleurs, la fréquence maximale estimée du circuit n $F_{max(Cn)}$ est une valeur recoupant plusieurs valeurs de fréquence maximale correspondant à plusieurs capteurs dans le circuit n, comme décrit en relation avec la figure 6.

En outre, ce graphique donne une valeur de la marge de sécurité minimale qu'on peut appliquer au circuit, afin d'anticiper les disparités dues au procédé de fabrication entre plusieurs circuits du même type. Dans cet exemple, l'erreur commise en fréquence d'horloge est, en valeur absolue, inférieure à 8 %. On peut donc retrancher à la fréquence maximale obtenue lors de la caractérisation l'équivalent de 8 % de la fréquence d'horloge.

Cette marge de sécurité n'est requise que dans les cas où l'on pourrait effectuer une moyenne de valeurs sur plusieurs capteurs (pour la détermination de la fréquence maximale estimée - Fig.6) et/ou plusieurs circuits (pour la détermination des marges de correction relative à un même capteur- Fig.9). A la différence des solutions de l'art antérieur, elle est parfaitement calibrée, car elle est obtenue à partir de mesures précises de la fréquence maximale absolue effectuées sur une multitude de circuits de conception identique.

De nombreuses variantes et modifications du procédé de calibration et du procédé de caractérisation apparaitront à l'homme du métier. En particulier, ces procédés pourront être appliqués en considérant des paramètres de fonctionnement du circuit autres que la fréquence et la tension d'alimentation. La tension de polarisation du circuit, au niveau de son substrat, a par exemple le même effet que la tension d'alimentation sur les contraintes temporelles du circuit. Ainsi, une caractérisation de la fréquence d'horloge maximale en fonction de cette tension de polarisation (ou inversement) peut être obtenue.

De même, plutôt que de considérer la fréquence d'horloge, on peut mener ces procédés en faisant varier la période du signal d'horloge. Même si une variation de la période d'horloge implique une variation de la fréquence - car il s'agit du même signal d'horloge et du même actionneur, une analyse temporelle ne produira pas les mêmes résultats qu'une analyse fréquentielle, car un incrément de la période d'horloge n'est pas équivalent à un incrément de la fréquence. Ainsi, le procédé de calibration permettra alors de calculer des marges de correction en temps, plutôt qu'en fréquence. La période minimale d'horloge (correspondant à la fréquence maximale) sera alors égale à la période d'horloge à laquelle le capteur de fautes temporelle voit une transition, plus une marge de temps (qui est négative).

Maintenant qu'on dispose de points de fonctionnement optimaux du circuit numérique, représentés par exemple par la courbe de la fréquence d'horloge maximale $F_{max}$ en fonction de la tension d'alimentation V, on souhaite que le circuit numérique fonctionne au plus près de ces points idéaux, et ce, même lorsque le circuit subit des variations brusques de ses paramètres de fonctionnement (chute de tension, hausse de la température...).

Des dispositifs de type « oscillateur en anneau » (« Ring oscillator » en anglais) ou de type « réplique de chemin critique » (« critical path replica ») sont couramment utilisés pour suivre les variations dynamiques des paramètres de fonctionnement. Ils permettent de détecter des dépassements de la fréquence maximale $F_{max}(V)$, provoqués par les variations dynamiques. Ainsi, lorsqu'un tel dépassement se produit, une réaction possible consiste à abaisser immédiatement la fréquence F du signal d'horloge pour compenser ces variations dynamiques.

La figure 12 représente une autre partie du circuit électronique numérique 300 incorporant un dispositif de suivi en ligne 1200 de type « réplique de chemin critique ». Un exemple de réalisation de ce dispositif est donné dans le document US2008/0104561.

Le dispositif de suivi en ligne 1200 a pour but de simuler le délai de propagation dans un chemin conducteur de données du circuit numérique, qui est le plus critique en termes de délai. Pour effectuer cette simulation, le dispositif 1200 comprend une réplique de chemin critique, c'est-à-dire un ensemble de portes logiques dont le délai de propagation varie de la même façon que le délai de propagation à travers le chemin critique. Ces portes logiques ne sont pas nécessairement les mêmes que dans le chemin conducteur de données critique.

Le dispositif 1200 est de préférence disposé à proximité d'un des coeurs du circuit 300 comprenant le chemin critique, de sorte que la réplique du chemin critique est soumise aux mêmes paramètres de fonctionnement (fréquence d'horloge, tension d'alimentation, de polarisation et température). Cela garantit une bonne corrélation entre le dispositif de suivi 1200 et le coeur du circuit qu'il surveille. Ainsi, lorsque des variations de ces paramètres ont lieu, la réplique est influencée de la même manière que le coeur du circuit. Il en découle que le délai de propagation dans la réplique de chemin critique varie de la même manière que le délai de propagation d'un signal de données parcourant le chemin critique.

Le dispositif 1200, cadencé par le signal d'horloge CLK, comprend en outre un convertisseur de type temps-numérique (« time-to-digital »). Il permet de quantifier un rapport ou un écart « critique » entre la période du signal d'horloge CLK et le temps de propagation « critique » d'un signal à travers le chemin critique. Le dispositif 1200 délivre une valeur numérique SIG, appelée signature. La signature SIG est, de préférence, un code thermométrique de plusieurs bits, par exemple 32 bits. On appelle « code thermométrique » une valeur numérique constituée d'un ou plusieurs bits consécutifs ayant le niveau logique '0' suivis d'un ou plusieurs bits consécutifs ayant le niveau logique '1', par exemple '00000011' ou '01111111'. Dans le cas du code thermométrique, le nombre de '1' logique est un indicateur directe du rapport susmentionné, qui est susceptible de varier au cours du temps (à cause notamment des variations dynamiques de la tension d'alimentation et/ou de la température).

La signature SIG en sortie du dispositif 1200 est dirigée en entrée d'un module de traitement 1210, configuré pour comparer la valeur du signal SIG à une signature de référence $SIG_{REF}$. La signature de référence $SIG_{REF}$ est également une valeur thermométrique, ayant le même nombre de bits que la signature SIG. Enregistrée dans une mémoire 1220, la référence SIG$_{REF}$ représente la valeur de code thermométrique qu'il ne faut pas dépasser ou ne pas atteindre (par valeurs inférieures ou supérieures) selon la convention choisie, pour assurer que le circuit est dans une zone de fonctionnement autorisé.

Le résultat de la comparaison entre les valeurs SIG et SIG$_{REF}$ prend la forme d'un signal de commande CMD, à destination des moyens de réglage 1230 des paramètres de fonctionnement du circuit. Ces paramètres de fonctionnement pouvant être réglés incluent la fréquence F du signal d'horloge CLK et au moins un autre paramètre choisi parmi, de façon non limitative la tension d'alimentation V, la tension de polarisation V$_{bias}$ du circuit numérique 300 et la température. Lorsque le signal SIG dépasse ou atteint (par valeurs inférieures ou valeur supérieures) la signature de référence SIG$_{REF}$, cela signifie que le rapport critique a changé, soit parce que la fréquence a changé, soit parce qu'un autre paramètre telle que la tension d'alimentation a changé entraînant une augmentation du délai de propagation dans la réplique de chemin critique.

Par analogie, cela signifie également que le délai de propagation dans le chemin critique a augmenté jusqu'à une valeur pouvant induire une violation temporelle. Au moins un paramètre de fonctionnement est alors commandé (via le signal CMD) pour empêcher une telle violation temporelle. Par exemple, la fréquence de signal d'horloge CLK est diminuée et/ou la tension d'alimentation V est augmentée (ce qui a en général pour effet de réduire le temps de propagation).

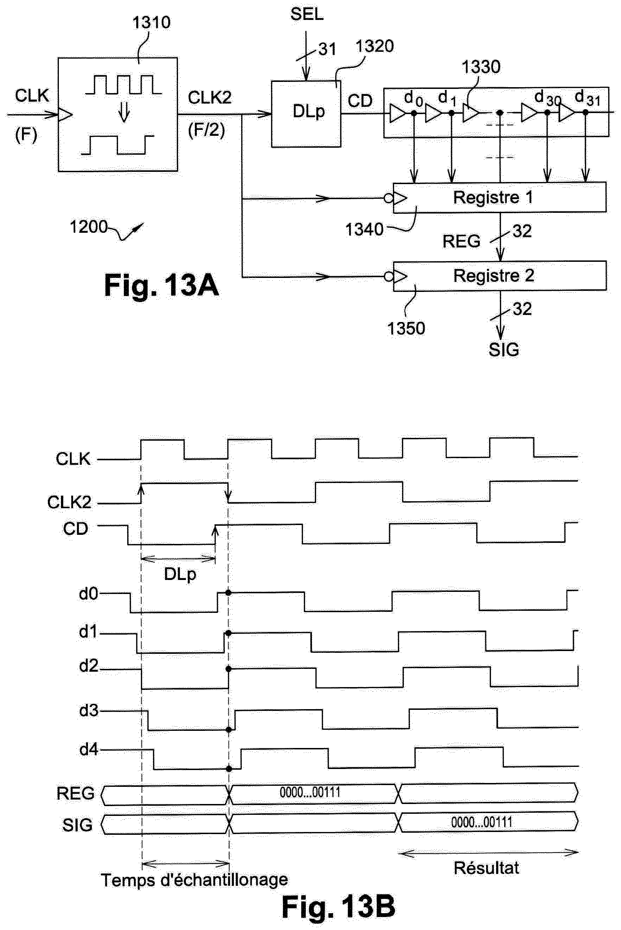

La figure 13A représente schématiquement un mode de réalisation du dispositif de suivi 1200, dans lequel le signal parcourant la réplique du chemin critique est un second signal d'horloge CLK2 ayant une fréquence réduite de moitié (F/2) par rapport à la fréquence F du signal CLK. Pour produire ce signal CLK2, le dispositif de suivi 1200 comprend un diviseur d'horloge 1310 recevant en entrée le signal d'horloge CLK.

La réplique du chemin critique comprend une chaîne de cellules de retard incluant avantageusement une cellule à retard programmable 1320 suivie d'une chaîne de cellules de délai 1330. Cette cellule de retard programmable 1320 reçoit en entrée le signal CLK2 et produit en sortie un signal CD. La cellule 1320 introduit dans le signal CLK2 qui la parcourt un retard DL$_P$, dont la valeur peut être réglée par l'intermédiaire d'un signal de sélection SEL. Cela permet d'adapter, pour chaque coeur du circuit numérique, la valeur du délai de propagation dans la réplique à celle du délai de propagation dans le chemin critique. La valeur du retard DL$_P$ est choisie dans cet exemple proche, mais légèrement inférieure, à la valeur du délai de propagation dans le chemin critique. Le retard introduit par chacune des cellules de délai 1330 est prévu le plus petit possible pour maximiser la précision du dispositif. La somme du retard DL$_P$ et des petits retards des cellules 1330 est supérieure à la valeur maximale possible du chemin critique (dans les conditions environnementales les plus défavorables).

Le signal CD est dirigé en entrée d'une chaîne de cellules de délai 1330, par exemple au nombre de 32. Les cellules de délai 1330 sont, par exemple, des cellules « buffers » non-inverseurs connectées en série les unes aux autres. Elles constituent une ligne de retards, de préférence tous identiques, échantillonnée par un premier registre 1340. Plus précisément, chacun des signaux do à d$_{31}$ en sortie des buffers 1330 est enregistré, à un instant donné, par une bascule du registre 1340 (le registre comporte donc, dans l'exemple ci-dessus, 32 bascules pour 32 bits). Les cellules 1320, 1330 et le registre 1340 forment ensemble la partie convertisseur temps-numérique du dispositif 1200. Dans l'exemple décrit, l'échantillonnage des signaux do à d$_{31}$, par enregistrement dans le registre 1340, est réalisé sur les fronts descendants du signal d'horloge CLK2.

Le dispositif de suivi 1200 comporte avantageusement un deuxième registre 1350, qui permet de stabiliser la donnée enregistrée par le premier registre 1340 (ce dernier pouvant être métastable). Le signal en sortie du deuxième registre 1350 constitue alors la signature thermométrique SIG. Les registres 1340 et 1350 sont, dans ce mode de réalisation préférentiel, cadencés par le signal d'horloge CLK2.

La figure 13B représente sous la forme de chronogrammes des signaux du dispositif de la figure 13A. « CLK » et « CLK2 » désignent les signaux d'horloge, respectivement en entrée et sortie du diviseur d'horloge 1310. « CD » correspond au signal en sortie de la cellule à retard programmable 1320. Dans un souci de clarté, seulement cinq des signaux en sortie des cellules 1330 sont représentés sur la figure 13B. Il s'agit des signaux do à d$_4$ correspondant aux cinq premières cellules 1330 de la chaîne. Enfin, « REG » et « SIG » sont les valeurs numériques stockées respectivement dans les registres 1340 et 1350, à chaque front actif du signal d'horloge CLK2 (le front descendant dans l'exemple de chronogrammes de la figure 13B).

Comme indiqué précédemment, le signal CLK2 possède une fréquence égale à la fréquence F du signal d'horloge CLK divisée par deux. Le signal CD en sortie de la cellule 1320 correspond au signal CLK2 présent à son entrée, décalé dans le temps d'une durée égale au retard DL$_P$. Chacun des signaux do à d$_4$ suivants est une reproduction du signal CD un peu plus décalée par rapport au signal CD

Les valeurs des signaux do à d$_{31}$ au front descendant du signal d'horloge CLK2 sont enregistrées dans le registre 1340. Dans l'exemple de la figure 13B, seuls les trois premiers signaux do à d$_2$ ont une valeur égale à '1', tandis que tous les signaux suivants (d$_3$ à d$_{31}$) sont à '0'. Le registre 1340 contient donc une valeur REG formée de 3 bits à '1' et le reste des bits à '0'. Cette même valeur se retrouve, un cycle d'horloge CLK2 plus tard, dans le registre 1350 et forme la signature SIG du dispositif de suivi en ligne 1200.

Le retard $DL_P$ est un retard important, dit « délai grossier », par rapport aux délais « fins » introduits par les buffers 1330. Le retard $DL_P$ correspond, par exemple, à 80%-90% du délai de propagation dans le chemin critique, tandis que les délais des buffers 1330 servent à échantillonner, le plus finement possible, le front montant du signal d'horloge CLK2 qui s'est propagé à travers la cellule 1320. Ainsi, la somme du retard $DL_P$ et d'une partie des délais des buffers 1330 correspond au délai de propagation dans le chemin critique.

Le fait d'utiliser une horloge CLK2 ayant une fréquence plus faible que l'horloge CLK et d'échantillonner les signaux do à $d_n$ sur un front de cette horloge CLK2 garantit que la valeur REG (et par conséquent la signature SIG) est sous une forme thermométrique. En effet, si l'on utilisait le signal d'horloge CLK d'origine, à la fois pour parcourir la réplique 1320 et pour cadencer les registres 1340-1350, le dernier bit $d_{31}$ risquerait d'être de même valeur que le bit do (par exemple « 100..00111 »). Cela voudrait dire que le cumul des délais 1330 (qui sépare do et $d_{31}$) est supérieur ou égal à la période d'horloge du signal CLK.

D'autres modes de réalisation du dispositif de suivi 1200 peuvent être envisagés. De façon générale, le dispositif de suivi utilise le signal d'horloge CLK qui cadence le fonctionnement du circuit que l'on souhaite surveiller au moyen du dispositif de suivi. Le dispositif de suivi 1200 inclut une chaîne de cellules de retard comprenant une cellule de retard principale et une série de cellules de retard fins, comme cela a été décrit précédemment. On notera que les cellules de retard fins ne sont pas nécessairement tous identiques, mais que cela peut simplifier la réalisation. En outre, le signal d'horloge envoyé en entrée de la chaîne de cellules de retard peut être le signal d'horloge principal CLK ou une horloge dérivée de CLK présentant de préférence une période plus faible pour faciliter la réalisation du dispositif de suivi.

Les sorties des cellules de retard (de tout ou partie de celles-ci) sont reliées à un registre qui permet de mémoriser les valeurs présentes en sortie des cellules de retard sur un front actif d'échantillonnage d'un signal d'horloge cadençant le registre. Le signal d'horloge d'échantillonnage est dérivé du signal d'horloge CLK. Le signal d'horloge d'échantillonnage pourrait être égal au signal CLK dans le cas par exemple où le signal d'horloge envoyé en entrée de la chaîne de cellules de retard est également le signal CLK. De façon générale, le temps T1 séparant l'instant d'injection d'un front actif en entrée de la chaîne de cellules et l'instant d'application d'un front actif d'échantillonnage sur le registre est égal à k*T, où k est un coefficient de proportionnalité et T la période du signal d'horloge CLK (T1= k*T). Afin de pouvoir bien suivre l'évolution de l'écart ou du rapport entre la période T du signal d'horloge et le délai traversant le chemin critique du circuit, il faut s'assurer que le temps de propagation $T_P$ à travers la chaîne de cellules de retard, entre son entrée et un point intermédiaire de la série de cellules de retard fins soit lui aussi lié au temps de propagation $T_{cri}$ à travers le chemin critique, selon la formule $T_p=k*T_{cri}$.

Le comportement du dispositif 1200 lors d'une variation dynamique d'un paramètre de fonctionnement va maintenant être décrit, à l'aide des chronogrammes de la figure 13B. Considérons tout d'abord que ces chronogrammes représentent un point de fonctionnement initial du circuit (correspondant à des valeurs présentes des paramètres de fonctionnement), proche d'un point de fonctionnement optimal du circuit. A ce point de fonctionnement initial, le dispositif de suivi 1200 délivre une signature SIG égale à '00...00111', soit trois bits à '1'.

Si une baisse de la tension d'alimentation se produit (à fréquence constante), par exemple parce que le circuit est davantage sollicité et provoque un appel de courant, le délai de propagation du front montant du signal d'horloge CLK2 dans les cellules 1320 et 1330 augmente. Le nombre de bits à '1' de la signature SIG diminue, car les signaux do à $d_{31}$ sont davantage décalés (vers la droite sur la figure 13) par rapport au front descendant du signal CLK2, qui sert de référence pour l'échantillonnage.

De façon similaire, si la fréquence F du signal d'horloge CLK/CLK2 augmente (i.e. la période d'horloge T diminue), le nombre de bits à '1' se réduit. Cela est dû au fait que l'échantillonnage du registre 1340 se produit plus rapidement par rapport au délai de propagation du signal d'horloge CLK2 (qu'on suppose inchangé). Une variation spontanée de la fréquence d'horloge peut notamment se produire si la boucle à verrouillage de fréquence (ou de phase) générant le signal d'horloge n'est pas stable.

Inversement, si la tension d'alimentation augmente (le délai de propagation se raccourcit) ou si la fréquence d'horloge diminue, le nombre de '1' dans la signature SIG augmente.

A de rares occasions, il peut arriver que la tension d'alimentation et la fréquence de fonctionnement varient simultanément. Deux cas se présentent alors :

- si la fréquence d'horloge et la tension d'alimentation évoluent dans des sens opposés, la valeur de la signature SIG est modifiée (par exemple, le nombre de '1' diminue lorsque la fréquence augmente et la tension diminue) ;
- si la fréquence d'horloge et la tension d'alimentation évoluent dans le même sens, il se peut que l'une de ces variations compense les effets de l'autre et que la signature SIG soit constante (par exemple, l'augmentation du délai de propagation provoquée par la diminution de la tension est compensée par une diminution de la fréquence).

Ainsi, la signature SIG fournie par le dispositif 1200 donne une information sur l'évolution des paramètres de fonctionnement, autrement dit l'évolution du point de fonctionnement du circuit. Une réduction du nombre de bits à '1' dans la signature SIG indique, d'après les exemples ci-dessus, une approche vers une zone de non-fonctionnement (ou, du moins, une zone dangereuse). Une contre-mesure, pour ramener le circuit dans une zone de fonctionnement correcte, est alors adoptée, comme décrit ci-dessus en relation avec la figure 12 (i.e. asservissement des moyens de réglage 1230 en fonction de l'écart avec la référence $SIG_{REF}$). A l'inverse, une augmentation du nombre de '1' est synonyme d'une augmentation de la marge de sécurité. Le circuit fonctionne de façon sous-optimale et devient moins efficace énergétiquement. A nouveau, la contre-mesure consiste à ramener le circuit dans un point de fonctionnement le plus proche possible d'un point de fonctionnement optimal.

Le comportement du dispositif 1200 traduit non seulement le « sens » dans lequel évolue le fonctionnement du circuit, mais également la magnitude du changement. En effet, le nombre de '1' en plus ou en moins dans la signature SIG quantifie l'amplitude de la variation en fréquence ou en tension (par exemple). Les contre-mesures pour compenser ces variations dynamiques de paramètres peuvent alors être adaptées en conséquence (via le signal CMD).

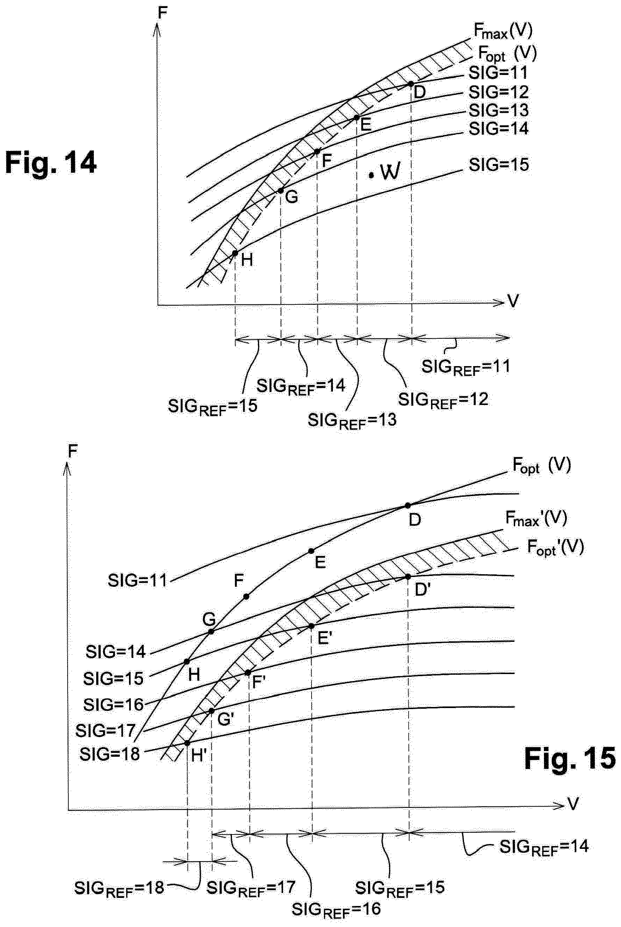

La figure 14 représente, sur un graphique de la fréquence d'horloge F en fonction de la tension d'alimentation V, les valeurs de signature SIG délivrés par le dispositif de suivi en ligne 1200. Par soucis de simplification, on a représenté uniquement les points de fonctionnement du circuit pour lesquels la signature SIG change. Plus précisément, les points de fonctionnement situés entre la courbe SIG=15 et la courbe SIG=14 conduisent à une valeur de signature délivrée égale à 15. En partant d'un point de fonctionnement entre ces deux courbes, l'augmentation de la fréquence ou la diminution de la tension va entraîner une modification de la signature délivrée pour un point de fonctionnement situé sur la courbe SIG=14. Plusieurs courbes correspondant à plusieurs changements de valeurs de signature (i.e. de 11 à 15) sont représentées. Les valeurs de la signature SIG sont ici simplifiées et indiquent le nombre de bits à '1'. Par exemple, « SIG = 13 » signifie qu'il y a 13 bits de valeur '1'.

Une courbe caractéristique $F_{max}(V)$ du fonctionnement du circuit, obtenue par exemple selon le procédé de caractérisation précédemment décrit, est superposée aux courbes de signature SIG du dispositif 1200. A cette courbe de la fréquence maximale $F_{max}(V)$ peut être ajoutée une marge de sécurité dite « dynamique », symbolisée par une zone hachurée sur la figure 14, pour obtenir une courbe $F_{opt}(V)$ de la fréquence optimale en fonction de la tension d'alimentation.

La marge de sécurité dynamique vaut, à titre d'exemple, 40 mV (chaque point de la courbe $F_{max}(V)$ est alors translaté horizontalement vers la droite de 40 mV). Elle permet notamment de compenser le bruit électrique dans le circuit et d'« amortir » les chutes de la tension d'alimentation V, évitant ainsi que le circuit entre dans un état de dysfonctionnement (au-dessus de la courbe $F_{max}(V)$).

La marge de sécurité dynamique peut être combinée à la marge de sécurité statique décrite en relation avec la figure 11. Ainsi, la marge de sécurité ajoutée peut avoir deux composantes, l'une statique pour tenir compte des variations du procédé de fabrication et l'autre dynamique pour tenir compte des variations environnementales (gradients de température, chute de tension...).

Pour rappel, les marges de sécurité, respectivement statique et dynamique, visent à garantir le fonctionnement du circuit pour respectivement compenser l'erreur (éventuelle) commise sur la détermination de la fréquence maximale $F_{max}$ et amortir les variations environnementales. Elles sont retranchées à la courbe $F_{max}(V)$ et ont par conséquent tendance à éloigner le point de fonctionnement du circuit de la courbe $F_{max}(V)$. Au contraire, la marge de correction $\Delta F_i$ vise à s'approcher de la limite de fonctionnement $F_{max}(V)$, partant des points de fonctionnement $F_d(V)$ détectés par les capteurs (cf. Fig.7).

On a représenté sur la courbe $F_{opt}(V)$ de la figure 14 des points de fonctionnement optimaux D à H du circuit correspondant au croisement des courbes SIG=11 à SIG=15 avec la courbe $F_{opt}(V)$.

Sur la figure 14, on constate que la valeur de signature SIG associée à un point de fonctionnement optimal varie selon la position de ce point sur la courbe $F_{opt}(V)$. Sur la base de ce constat, on prévoit de définir une valeur de signature de référence $SIG_{REF}$ pour chaque tronçon de la courbe $F_{opt}(V)$ définis entre deux points successifs D à H ou au-delà des points extrêmes. Cette signature de référence servira alors de signature d'alerte afin de faire en sorte que le point de fonctionnement du circuit (F,V) reste toujours dans une zone autorisée (pour éviter les fautes), la zone autorisée étant dans cet exemple les points de fonctionnement situés à droite de la courbe $F_{max}(V)$, et de préférence à droite de la courbe $F_{opt}(V)$ pour prendre une marge.

A titre d'exemple, si le point de fonctionnement présent est le point W représenté en figure 14, avec une signature courante égale à SIG=15 (le point W étant entre SIG=15 et SIG=14, dans la plage de tensions définie par les valeurs de tension des points E et D), on pourra sans problème augmenter la fréquence jusqu'à atteindre la courbe SIG 12 ou on pourra diminuer la tension jusqu'à atteindre la courbe SIG14. Au-delà de ces courbes respectives, le circuit est susceptible de présenter des erreurs.

On prévoit ainsi d'associer une signature de référence à chaque tronçon de la courbe $F_{opt}(V)$. On notera que pour un tronçon donné, par exemple le tronçon E-D, on pourra mémoriser une valeur de signature SIG égale à 12 ou 13, selon que l'on veut mémoriser la valeur à ne pas atteindre ou la valeur à ne pas dépasser.

En outre, on notera que le dispositif de suivi est de préférence choisi de sorte que les courbes SIG présentent, au moins pour une plage de valeurs de tension donnée, une monotonie semblable à celle des fonctions $F_{max}(V)$ et

$F_{opt}(V)$. Dans ce cas, la connaissance du point de fonctionnement présent permet de déterminer à proximité de quel tronçon de la courbe $F_{opt}(V)$ se situe le point de fonctionnement présent et l'on peut ainsi éviter que le point de fonctionnement ne franchisse la courbe $F_{opt}(V)$ en surveillant la signature délivré par le dispositif de suivi et en faisant en sorte qu'elle ne dépasse pas la valeur de signature associée au tronçon considéré.

Une façon simple de mettre en pratique cette surveillance, est de définir des plages de valeurs de la tension d'alimentation V correspond aux tronçons et d'attribuer à chaque plage de tensions, une valeur de la signature de référence $SIG_{REF}$. La valeur $SIG_{REF}$ affectée à chaque plage correspond à la courbe de signature SIG, qui est la plus proche de la courbe $F_{opt}(V)$ sur le tronçon considéré, sans pour autant la dépasser sur la plage de tensions considérée. Choisir une courbe de signature plus éloignée reviendrait à considérer une marge de sécurité plus importante, et donc à contraindre le circuit à un fonctionnement non optimisé.

A titre d'illustration, au-delà du point D sur la courbe $F_{opt}(V)$, la courbe de signature la plus proche est celle correspondant à la valeur SIG = 11. On affecte alors, à la plage de tensions supérieure à la tension correspondant au point D une valeur de référence $SIG_{REF}$ égale à 11. Dans la plage de tension V située entre les points D et E, la courbe SIG = 11 dépasse la fréquence optimale $F_{opt}(V)$, il faut donc choisir une valeur de signature supérieure, en l'occurrence SIG = 12.

Ainsi, une fois que les signatures de référence ont été associées à des plages de tensions différentes, et l'ensemble mémorisé dans la mémoire MEM, il est possible que le dispositif 1210 définisse plus précisément les commandes CMD, connaissant le point de fonctionnement présent du circuit. Le dispositif recherche ainsi dans la mémoire 1220 la signature de référence associée à la plage de valeurs de tension dans laquelle se situe le point de fonctionnement présent et compare cette signature de référence à la signature délivrée par le dispositif de suivi 1200. La commande CMD est ainsi définie sur la base de cette comparaison. Plus la signature délivrée par le dispositif de suivi est éloignée de la signature de référence considérée pour la plage de tensions courante, plus il sera possible de faire varier les paramètres de fonctionnement pour se rapprocher de la courbe $F_{opt}(V)$ si l'on souhaite s'en écarter le moins possible pour des raisons énergétiques. D'autres stratégies de commande peuvent également être mises en oeuvre par le dispositif 1230 en fonction du résultat de la comparaison entre la signature courant délivrée par le dispositif de suivi 1200 et la signature de référence considérée.

On procède ainsi pour chaque plage de tensions d'alimentation V associée à un tronçon. Entre les points E et F, la plus faible valeur de signature acceptable est SIG = 13, d'où $SIG_{REF}$ = 13. Entre les points F et G, la valeur de signature est $SIG_{REF}$ = 14. Enfin, entre les points G et H, la valeur de signature est $SIG_{REF}$ = 15. Les différentes signatures de référence $SIG_{REF}$ sont enregistrées dans la mémoire 1220 du circuit 300 (Fig.12).

Dans la pratique, la détermination des valeurs de signature de référence $SIG_{REF}$ à considérer selon la valeur du point de fonctionnement courant du circuit peut être réalisée par le module de traitement 1210 qui est couplé au dispositif de suivi en ligne 1200. Le protocole de détermination est décrit ci-après.

Dans une première étape, on cherche à obtenir les différentes courbes SIG et la courbe $F_{max}(V)$. On peut ainsi réaliser de façon itérative, pour plusieurs valeurs de tension d'alimentation appliquées au circuit, les opérations suivantes :

- faire fonctionner le circuit à différentes valeurs de fréquence, par exemple en partant d'une fréquence basse et en l'augmentant progressivement et relever les fréquences correspondant à des changements de valeur de signature, pour obtenir des points respectivement de chacune des courbes SIG, pour la valeur de tension présente ;
- déterminer une valeur $F_{max}$ de la fréquence d'horloge, par exemple en utilisant le procédé de caractérisation décrit plus haut (le balayage fréquentiel utilisé pour trouver les points des courbes SIG étant avantageusement utilisé pour déterminer $F_{max}$ correspondant à la tension présente selon le procédé précédemment décrit).

Dans une seconde étape, on détermine éventuellement une courbe $F_{opt}(V)$ à partir de $F_{max}(V)$ si on souhaite prendre une marge de sécurité sur l'un ou plusieurs des paramètres de fonctionnement, par exemple la tension.

On recherche ensuite quelle est, dans la zone de fonctionnement autorisé, la courbe SIG la plus proche d'un tronçon de la courbe $F_{opt}(V)$ si on a pris une marge, ou de la courbe $F_{max}$ si on ne prend pas de marge. Si ce n'est pas toujours la même courbe SIG qui est la plus proche de la courbe $F_{opt}(V)$ ou $F_{max}(V)$, on définit pour plusieurs tronçons de la courbe les courbes SIG qui sont respectivement les plus proches.

Pour chaque tronçon de courbe retenu, on définit une zone de points de fonctionnement incluant le tronçon pour lesquels on va considérer que la signature de référence à ne pas dépasser ou atteindre est celle de la courbe SIG la plus proche du tronçon. Dans l'exemple décrit précédemment une zone est définie par une plage de valeurs de tension ; néanmoins, il est envisageable de définir chaque zone au moyen de plusieurs paramètres de fonctionnement.

On enregistre ensuite la valeur $SIG_{REF}$ et la définition de la zone de points de fonctionnement associée dans la mémoire 1220 couplé au module de traitement 1210.

De préférence, lors de l'application du protocole susmentionné, l'ensemble du circuit 300 est actif, par exemple en appliquant des motifs de test appropriés pour mettre en oeuvre le procédé de détermination de la fonction $F_{max}$, afin que le dispositif de suivi 1200 soit dans des conditions environnementales (température notamment) proches de celles du circuit 300 lorsqu'il est actif.

La marge de sécurité pourrait être exprimée en fréquence, par exemple 50 MHz, plutôt qu'en tension, pour tenir compte des fluctuations du signal d'horloge (« jitter »). La courbe $F_{opt}(V)$ serait alors obtenue en translatant la courbe $F_{max}(V)$ « vers le bas » en retranchant la marge de sécurité à la fréquence maximale d'horloge $F_{max}(V)$, pour une tension donnée. La marge de sécurité peut aussi résulter d'une combinaison d'une marge en tension et d'une marge en fréquence. Dans ce dernier cas, on obtiendrait la courbe $F_{opt}(V)$ en réalisant deux translations (sur la gauche et vers le bas).

Après que les valeurs de référence $SIG_{REF}$ aient été enregistrées, le dispositif de suivi en ligne 1200 et le module de traitement 1210 peuvent être utilisés comme cela a été décrit en relation avec la figure 12, pour détecter un rapprochement, voire un dépassement, du point de fonctionnement présent du circuit de la courbe $F_{opt}(V)$ (ou éventuellement de la courbe $F_{max}$ si aucune marge n'est prise). Cette information de rapprochement, voire de dépassement, peut avantageusement être utilisée pour assurer le bon fonctionnement du circuit par maintien du point de fonctionnement présent dans la zone autorisée en commandant le dispositif actionneur 1230. Cette information peut également être utilisée pour maintenir le point de fonctionnement du circuit le plus près possible de la courbe $F_{opt}(V)$ pour optimiser la consommation énergétique du circuit tout en assurant un bon fonctionnement, notamment dans des périodes de changement du point de fonctionnement.

Grâce au fait qu'on est désormais capable de déterminer rapidement et simplement les points de fonctionnement optimaux du circuit numérique situés sur la courbe $F_{opt}(V)$ (ou $F_{max}$ si aucune marge n'est prise), en utilisant le procédé de caractérisation selon l'invention, les valeurs de signature de référence $SIG_{REF}$ et les zones de point de fonctionnement associées peuvent être mises à jour à plusieurs reprises au cours de la vie du circuit.

A titre d'exemple, sur la figure 15, une nouvelle caractérisation du circuit numérique a permis d'établir la courbe de fréquence maximale $F_{max}'(V)$, à un autre instant de la durée de vie du circuit. La courbe $F_{opt}'(V)$, obtenue à partir de la courbe $F_{max}'(V)$ et d'une marge de sécurité, représente la courbe de fonctionnement optimal à ce même instant.

La courbe $F_{opt}(V)$ de la figure 14 est également représentée sur la figure 15, à titre de comparaison. La différence entre les courbes $F_{opt}'(V)$ et $F_{opt}(V)$ s'explique, par exemple, par le vieillissement du circuit ou par de nouvelles conditions environnementales, induisant dans cet exemple une diminution des performances temporelles au cours du temps ($F_{max}'(V) < F_{max}(V)$).

La courbe $F_{opt}'(V)$ est distincte de la précédente caractéristique $F_{opt}(V)$. Elle croise d'autres courbes de signature SIG, par exemple les courbes de valeur comprise entre 14 et 18. Les nouveaux points d'intersection sont notés D' à H' sur la figure 15. Par conséquent, d'autres valeurs de référence $SIG_{REF}$ peuvent être associées à de nouveaux tronçons reliant ces nouveaux points d'intersection. Les tronçons sont par exemple associés à des plages de valeurs de la tension d'alimentation V et une valeur de référence $SIG_{REF}$ est mesurée par plage, comme décrit ci-dessus en relation avec la figure 14.

La figure 15 représente une évolution du fonctionnement optimal possible au cours du temps. La période de temps s'écoulant entre deux caractérisations successives (D et D') est, par exemple, de l'ordre de quelques jours, soit une durée bien supérieure au temps de calcul nécessaire pour mettre en oeuvre le procédé de caractérisation de la fréquence $F_{max}$, et la mise à jour correspondante des valeurs mémorisées dans la mémoire 1220.

## Revendications

1. Procédé de calibration d'un circuit numérique (300) comprenant :

   - une pluralité d'éléments séquentiels (301, 302) ;
   - des chemins conducteurs de données (303) entre les éléments séquentiels ;
   - un arbre d'horloge (305) délivrant un signal d'horloge (CLK) pour cadencer les éléments séquentiels ; et
   - un capteur de fautes temporelles (304) de type préventif couplé à l'un (302) des éléments séquentiels, recevant en entrée un signal de données (D) arrivant sur l'élément séquentiel et configuré pour détecter pendant une fenêtre de détection (W) une transition du signal de données (D) ;
   - des moyens de réglage d'au moins un premier et un second paramètre de fonctionnement du circuit numérique ;

   le procédé est **caractérisé par** les étapes suivantes :

   a) activer un chemin conducteur de données (303) jusqu'à l'élément séquentiel (302) couplé au capteur (304) ;
   b) déterminer, pour une valeur donnée du premier paramètre (V1, F1), une première valeur ($F_{d1}$, $V_{d1}$) du second paramètre à partir de laquelle le capteur détecte une transition du signal de données pendant la fenêtre de détection, lesdites valeurs des premier (V1, F1) et second ($F_{d1}$, $V_{d1}$) paramètres définissant un point de fonctionnement de détection (A) du circuit numérique ;

c) déterminer, pour ladite valeur du premier paramètre (V1, F1), une seconde valeur ($F_{M(c1)}$) du second paramètre au-delà de laquelle le circuit numérique est en dysfonctionnement ;

d) calculer, pour le point de fonctionnement de détection (A), une marge de correction ($\Delta F_{c1}$) égale à la différence entre les première ($F_{d1}$) et seconde valeurs ($F_{M(c1)}$) du second paramètre.

2. Procédé selon la revendication 1, dans lequel les étapes a) à d) sont mises en oeuvre pour une pluralité de circuits témoin ayant une structure identique au circuit numérique (300), pour une même valeur donnée du premier paramètre, de sorte à obtenir plusieurs marges de correction ($\Delta F_{c1}$, $\Delta F_{c2}$, $\Delta F_{c3}$) relatives au capteur (304), et comprenant en outre une étape de détermination d'une marge de correction optimale ($\Delta F_1$) associé à la valeur du premier paramètre des points de fonctionnement de détection (A1 ; A2 ; A3) à partir des marges de correction ($\Delta F_{c1}$, $\Delta F_{c2}$, $\Delta F_{c3}$) relatives au capteur (304).

3. Procédé selon la revendication 2, dans lequel la marge de correction optimale ($\Delta F_1$) est une moyenne arithmétique des marges de correction ($\Delta F_{c1}$, $\Delta F_{c2}$, $\Delta F_{c3}$) relatives au capteur (304).

4. Procédé selon la revendication 2, dans lequel la marge de correction optimale ($\Delta F_1$) est la plus faible ($\Delta F_{c1}$) des marges de correction relatives au capteur (304).

5. Procédé selon l'une quelconque des revendications 1 à 4, dans lequel l'un des premier et second paramètres est choisi parmi la fréquence et la période du signal d'horloge et dans lequel l'autre des premier et second paramètres est choisi parmi la tension d'alimentation et la tension de polarisation du circuit numérique.

6. Procédé selon la revendication 5, dans lequel le second paramètre est la fréquence du signal d'horloge (F) et chaque marge de correction ($\Delta F_{c1}$, $\Delta F_{c2}$, $\Delta F_{c3}$) est une marge en fréquence.

7. Procédé selon la revendication 5, dans lequel le second paramètre est la période du signal d'horloge et chaque marge de correction est une marge en temps.

8. Procédé selon la revendication 5, dans lequel le second paramètre est choisi parmi la tension d'alimentation (V) et la tension de polarisation ($V_{bias}$) du circuit numérique et chaque marge de correction ($\Delta V_{c1}$) est une marge en tension.

9. Procédé selon l'une quelconque des revendications 1 à 8, dans lequel la seconde valeur ($F_{M(c1)}$) du second paramètre est obtenue en activant un chemin conducteur de données (303) critique et en modifiant progressivement le second paramètre (F, V) jusqu'à provoquer une violation temporelle du signal de données (D) reçu par l'élément séquentiel (302) disposé sur le chemin critique, par rapport à un front actif du signal d'horloge (CLK).

10. Procédé selon l'une quelconque des revendications 1 à 9, dans lequel les étapes a) à d) sont mises en oeuvre pour plusieurs valeurs du premier paramètre (V1, F1).

11. Procédé de caractérisation d'un circuit intégré consistant à déterminer à un instant donné de la vie du circuit un point de fonctionnement optimal (A') du circuit numérique comprenant :

- une pluralité d'éléments séquentiels (301, 302) ;
- des chemins conducteurs de données (303) entre les éléments séquentiels ;
- un arbre d'horloge (305) délivrant un signal d'horloge (CLK) pour cadencer les éléments séquentiels ; et
- un capteur de fautes temporelles (304) de type préventif couplé à l'un (302) des éléments séquentiels, recevant en entrée un signal de données (D) arrivant sur l'élément séquentiel et configuré pour détecter, pendant une fenêtre de détection (W) une transition du signal de données (D) ;
- des moyens de réglage d'au moins un premier et un second paramètre de fonctionnement du circuit numérique ;

le procédé est **caractérisé par** les étapes suivantes :

e) activer un chemin conducteur de données (303) jusqu'à l'élément séquentiel (302) couplé au capteur (304) ;
f) déterminer, pour une valeur donnée du premier paramètre (V1, F1), une première valeur ($F_{d1}$, $V_{d1}$) du second paramètre à partir de laquelle le capteur détecte une transition du signal de données pendant la fenêtre de détection, lesdites valeurs des premier (V1, F1) et second ($F_{d1}$, $V_{d1}$) paramètres définissant un point de fonctionnement de détection (A) du circuit numérique ;
g) déterminer un point de fonctionnement optimal (A') associé au point de fonctionnement de détection, en ajoutant à la première valeur ($F_{d1}$, $V_{d1}$) du second paramètre, une marge de correction ($\Delta F_1$, $\Delta V_1$) prédéterminée en lien avec une valeur limite du deuxième paramètre qui entrainerait un dysfonctionnement du circuit numérique, pour la valeur donnée du premier paramètre, ladite marge de correction étant associée à la valeur donnée du premier paramètre du point de fonctionnement de détection (A).

**12.** Procédé selon la revendication 11, dans lequel la marge de correction prédéterminée est mémorisée dans une mémoire du circuit ou est calculée à partir d'une relation fonctionnelle mémorisée dans le circuit ; les valeurs ou la relation fonctionnelle mémorisées étant obtenues par la mise en oeuvre d'un procédé de calibration selon l'une des revendications 1 à 10.

**13.** Procédé selon l'une des revendications 11 et 12, dans lequel les étapes e) à g) sont mises en oeuvre pour plusieurs valeurs du premier paramètre (V1, F1).

**14.** Procédé selon l'une quelconque des revendications 11 à 13, dans lequel, lorsque le circuit (300) comprend une pluralité de capteurs de fautes temporelles (304) de type préventif couplés chacun à l'un (302) des éléments séquentiels, les étapes e) à g) sont mises en oeuvre pour chaque capteur, de sorte à obtenir une pluralité de points de fonctionnement corrigés (A', B', C') ayant la même valeur du premier paramètre (V1, F1), le procédé comprenant en outre une étape de détermination, à partir de la pluralité de points de fonctionnement corrigés (A', B', C'), d'un unique point de fonctionnement optimal (A') associé à la valeur considérée du premier paramètre.

**15.** Procédé selon la revendication 14, dans lequel l'unique point de fonctionnement optimal est défini par ladite valeur du premier paramètre (V1, F1) et une moyenne arithmétique desdites valeurs du second paramètre ($F_{max1}$, $F_{max2}$, $F_{max3}$, $V_{min1}$, $V_{min2}$, $V_{min3}$) de la pluralité de points de fonctionnement corrigés (A', B', C').

**16.** Procédé selon la revendication 14, dans lequel le second paramètre est la fréquence du signal d'horloge (F) et l'unique point de fonctionnement optimal (A') est défini par ladite valeur du premier paramètre (V1) et de la plus faible ($F_{max1}$) desdites valeurs du second paramètre de la pluralité de points de fonctionnement corrigés (A', B', C').

**17.** Procédé selon la revendication 14, dans lequel le second paramètre est la tension d'alimentation (V) du circuit numérique (300) et l'unique point de fonctionnement optimal (A') est défini par ladite valeur du premier paramètre (F1) et la plus grande ($V_{min1}$) desdites valeurs du second paramètre de la pluralité de points de fonctionnement corrigés (A', B', C').

**18.** Procédé selon l'une quelconque des revendications 1 à 17, dans lequel la fenêtre de détection (W) est localisée avant un front actif du signal d'horloge (CLK).

**19.** Procédé selon l'une quelconque des revendications 1 à 18, dans lequel la fenêtre de détection (W) vaut entre 10 % et 50 % d'une période du signal d'horloge (CLK).

**20.** Circuit électronique numérique comprenant :

- une pluralité d'éléments séquentiels (301, 302) ;
- des chemins conducteurs de données (303) entre les éléments séquentiels, au moins un des chemins conducteurs de données (303) étant critique en termes de délai de propagation des données ;
- un arbre d'horloge (305) délivrant un signal d'horloge (CLK) pour cadencer les éléments séquentiels ; et
- un capteur de fautes temporelles (304) de type préventif couplé à l'un (302) des éléments séquentiels, recevant en entrée un signal de données (D) arrivant sur l'élément séquentiel et configuré pour détecter, pendant une fenêtre de détection (W) une transition du signal de données (D) ;
- des moyens de réglage d'au moins un premier et un second paramètres de fonctionnement du circuit numérique ;

**caractérisé en ce qu'**il comporte un contrôleur configuré pour mettre en oeuvre, lors d'une phase de caractérisation, les étapes suivantes :

e) activer un chemin conducteur de données (303) jusqu'à l'élément séquentiel (302) couplé au capteur (304) ;
f) déterminer, pour une valeur donnée du premier paramètre (V1, F1), une première valeur ($F_{d1}$, $V_{d1}$) du second paramètre à partir de laquelle le capteur détecte une transition du signal de données pendant la fenêtre de détection, lesdites valeurs des premier (V1, F1) et second ($F_{d1}$, $V_{d1}$) paramètres définissant un point de fonctionnement de détection (A) du circuit numérique ;

g) déterminer un point de fonctionnement optimal (A') associé au point de fonctionnement de détection, en ajoutant à la première valeur ($F_{d1}$, $V_{d1}$) du second paramètre, une marge de correction ($\Delta F_1$, $\Delta V_1$) prédéterminée en lien avec une valeur limite du deuxième paramètre qui entrainerait un dysfonctionnement du circuit numérique, pour la valeur donnée du premier paramètre, ladite marge de correction étant associée à la valeur donnée du premier paramètre du point de fonctionnement de détection (A).

**21.** Circuit selon la revendication 20, dans lequel le contrôleur est en outre configuré pour mettre en oeuvre, lors d'une phase de calibration, les étapes suivantes :

a) activer un chemin conducteur de données (303) jusqu'à l'élément séquentiel (302) couplé au capteur (304) ;

b) déterminer, pour une valeur donnée du premier paramètre (V1, F1), une première valeur ($F_{d1}$, $V_{d1}$) du second paramètre à partir de laquelle le capteur détecte une transition du signal de données pendant la fenêtre de détection, lesdites valeurs des premier (V1, F1) et second ($F_{d1}$, $V_{d1}$) paramètres définissant un point de fonctionnement de détection (A) du circuit numérique ;

c) déterminer, pour ladite valeur du premier paramètre (V1, F1), une seconde valeur ($F_{M(c1)}$) du second paramètre au-delà de laquelle le circuit numérique est en dysfonctionnement ;

d) calculer, pour le point de fonctionnement de détection (A), une marge de correction ($\Delta F_{c1}$) égale à la différence entre les première ($F_{d1}$) et seconde valeurs ($F_{M(c1)}$) du second paramètre.

**22.** Circuit selon l'une des revendications 20 et 21, comportant :

- un dispositif de suivi en ligne (1200) du fonctionnement du circuit numérique (300), comprenant une chaîne de cellules de retard (1320 ; 1330) dont le délai de propagation varie de la même façon que le délai de propagation à travers le chemin critique et configuré pour délivrer une signature numérique (SIG) représentative d'un rapport entre la période dudit signal d'horloge (CLK) et le délai de propagation à travers le chemin critique ; et

- un module de traitement (1210) configuré pour comparer la signature numérique (SIG) issue du dispositif de suivi (1200) à une signature de référence ($SIG_{REF}$), le résultat de la comparaison étant utilisé pour commander les moyens de réglage des premier et second paramètres de fonctionnement (F, V, $V_{bias}$).

**23.** Circuit selon la revendication 22, dans lequel ledit contrôleur est en outre configuré pour déterminer un ensemble de points de fonctionnement optimaux ($F_{opt}(V)$, V) du circuit numérique, l'ensemble des points de fonctionnement optimaux constituant une courbe de fonctionnement optimal ($F_{opt}(V)$) délimitant respectivement des zones de fonctionnement souhaité et non souhaité, et dans lequel ledit contrôleur est en outre configuré pour :

- identifier des tronçons de la courbe de fonctionnement optimal ($F_{opt}(V)$) pour lesquels la signature numérique (SIG) délivrée par le dispositif de suivi en ligne (1200) a une seule valeur ;

- enregistrer dans une mémoire (1220) couplée au module de traitement (1210) une zone de points de fonctionnement correspondant à chaque tronçon identifié et la signature de référence associée, la signature de référence associée étant fonction de la valeur de signature numérique délivrée par le dispositif de suivi en ligne pour les points de fonctionnement du tronçon identifié ;

- sélectionner, dans la mémoire (1220), la signature de référence associée à la zone de points de fonctionnement incluant un point de fonctionnement courant (W) du circuit numérique, la signature de référence sélectionnée étant utilisée par le module de traitement (1210) pour commander les moyens de réglage des paramètres de fonctionnement.

**Patentansprüche**

**1.** Kalibrierungsverfahren eines digitalen Schaltkreises (300), umfassend:

- eine Vielzahl von Sequenzelementen (301, 302);
- einen Leitpfad der Daten (303) zwischen den Sequenzelementen;
- einen Uhrenbaum (305), der ein Uhrensignal (CLK) ausgibt, um die Sequenzelemente zu takten; und
- einen Sensor für Zeitfehler (304) vom präventiven Typ, der an eines (302) der Sequenzelemente gekoppelt ist und am Eingang ein Datensignal (D) empfängt, das an dem Sequenzelement eintrifft und konfiguriert ist, um während eines Erfassungsfensters (W) einen Übergang des Datensignals (D) zu erfassen,
- Einstellmittel wenigstens eines ersten und eines zweiten Betriebsparameters des digitalen Schaltkreises;

wobei das Verfahren durch die folgenden Schritte gekennzeichnet ist:

a) Aktivierung eines Leitpfades der Daten (303) bis zum an den Sensor (304) gekoppelten Sequenzelement (302);

b) für einen bestimmten Datenwert des ersten Parameters (V1, F1) Bestimmung eines ersten Wertes ($F_{d1}$, $V_{d1}$) des zweiten Parameters, von dem aus der Sensor während des Erfassungsfensters einen Übergang des Datensignals erfasst, wobei die genannten Werte der ersten (V1, F1) und zweiten ($F_{d1}$, $V_{d1}$) Parameter einen Betriebspunkt der Erfassung (A) des digitalen Schaltkreises definieren;

c) für den genannten Wert des ersten Parameters (V1, F1) Bestimmung eines zweiten Wertes ($F_{M(C1)}$) des zweiten Parameters, ab dem der digitale Schaltkreis eine Störung aufweist;

d) für den Betriebspunkt der Erfassung (A) Berechnung einer Korrekturmarge ($\Delta F_{c1}$) gleich der Differenz zwischen den ersten ($F_{d1}$) und zweiten ($F_{M(C1)}$) Werten des zweiten Parameters;

2. Verfahren gemäß Anspruch 1, bei dem die Schritte a) bis d) für eine Vielzahl von Vergleichsschaltkreisen mit einer identischen Struktur im digitalen Schaltkreis (300) für einen und denselben bestimmten Wert des ersten Parameters derart umgesetzt sind, dass mehrere Korrekturmargen ($\Delta F_{c1}$, $\Delta F_{c2}$, $\Delta F_{c3}$) relativ zu dem Sensor (304) erhalten werden, und umfassend darüber hinaus einen Bestimmungsschritt einer optimalen Korrekturmarge ($\Delta F_{c1}$), die dem Wert des ersten Parameters der Betriebspunkte der Erfassung (A1; A2; A3) ausgehend von den Korrekturmargen ($\Delta F_{c1}$, $\Delta F_{c2}$, $\Delta F_{c3}$) relativ zu dem Sensor (304) zugeordnet sind.

3. Verfahren gemäß Anspruch 2, bei dem die optimale Korrekturmarge ($\Delta F_{c1}$) ein arithmetisches Mittel der Korrekturmargen ($\Delta F_{c1}$, $\Delta F_{c2}$, $\Delta F_{c3}$) relativ zu dem Sensor (304) ist.

4. Verfahren gemäß Anspruch 2, bei dem die optimale Korrekturmarge ($\Delta F_{c1}$) die niedrigste ($\Delta F_{c1}$) der Korrekturmargen relativ zu dem Sensor (304) ist.

5. Verfahren gemäß irgendeinem der Ansprüche 1 bis 4, bei dem einer des ersten und zweiten Parameters aus der Frequenz und der Periode des Uhrensignals ausgewählt ist und bei dem der andere des ersten und zweiten Parameters aus der Versorgungsspannung und der Polarisierungsspannung des digitalen Schaltkreises ausgewählt ist.

6. Verfahren gemäß Anspruch 5, bei dem der zweite Parameter die Frequenz des Uhrensignals (F) ist und jede Korrekturmarge ($\Delta F_{c1}$, $\Delta F_{c2}$, $\Delta F_{c3}$) eine Marge in der Frequenz ist.

7. Verfahren gemäß Anspruch 5, bei dem der zweite Parameter die Periode des Uhrensignals ist und jede Korrekturmarge eine Marge in der Zeit ist.

8. Verfahren gemäß Anspruch 5, bei dem der zweite Parameter aus der Versorgungsspannung (V) ausgewählt ist und die Polarisierungsspannung ($V_{bias}$) des digitalen Schaltkreises und jeder Korrekturmarge ($\Delta V_{c1}$) eine Spannungsmarge ist.

9. Verfahren gemäß irgendeinem der Ansprüche 1 bis 8, bei dem der zweite Wert ($F_{M(c1)}$) des zweiten Parameters durch Aktivieren eines kritischen Leitpfades von Daten (303) und durch progressives Modifizieren des zweiten Parameters (F, V) bis zum Hervorrufen eines zeitlichen Verstoßes des Datensignals (D), das vom Sequenzelement (302) empfangen wird, das auf dem kritischen Pfad angeordnet ist, im Verhältnis zu einer aktiven Front des Uhrensignals (CLK) erhalten wird.

10. Verfahren gemäß irgendeinem der Ansprüche 1 bis 9, bei dem die Schritte a) bis d) für mehrere Werte des ersten Parameters (V1, F1) umgesetzt sind.

11. Charakterisierungsverfahren eines integrierten Schaltkreises, bestehend in der Bestimmung eines optimalen Betriebspunktes (A') des digitalen Schaltkreises zu einem bestimmten Zeitpunkt des Lebens des Schaltkreises, umfassend:

- eine Vielzahl von Sequenzelementen (301, 302);
- Leitpfade der Daten (303) zwischen den Sequenzelementen;
- einen Uhrenbaum (305), der ein Uhrensignal (CLK) zum Takten der Sequenzelemente ausgibt; und
- einen Sensor für Zeitfehler (304) vom präventiven Typ, der an eines der Sequenzelemente (302) gekoppelt ist und am Eingang ein Datensignal (D) empfängt; das auf dem Sequenzelement eintrifft und konfiguriert ist;

um während eines Erfassungsfensters (W) einen Übergang des Datensignals (D) zu erfassen;
- Einstellmittel wenigstens eines ersten und eines zweiten Betriebsparameters des digitalen Schaltkreises;

wobei das Verfahren durch die folgenden Elemente gekennzeichnet ist: e)

Aktivierung eines Leitpfandes der Daten (303) bis zum an den Sensor (304) gekoppelten Sequenzelement (302);
f) Für einen bestimmten Datenwert des ersten Parameters (V1, F1) Bestimmung eines ersten Wertes ($F_{d1}$, $V_{d1}$) des zweiten Parameters, von dem aus der Sensor während des Erfassungsfensters einen Übergang des Datensignals erfasst, wobei die genannten Werte des ersten (V1, F1) und zweiten ($F_{d1}$, $V_{d1}$) Parameters einen Betriebspunkt der Erfassung (A) des digitalen Schaltkreises definieren;
g) Bestimmung eines optimalen Betriebspunktes (A'), der dem Betriebspunkt der Erfassung zugeordnet ist, durch Hinzufügen einer vorbestimmten Korrekturmarge ($\Delta F_1$, $\Delta V_1$) zu dem ersten Wert ($F_{d1}$, $V_{d1}$) des zweiten Parameters im Zusammenhang mit einem Grenzwert des zweiten Parameters, der eine Störung des digitalen Schaltkreises nach sich ziehen würde, für den bestimmten Wert des ersten Parameters, wobei die genannten Korrekturmarge dem bestimmten Wert des ersten Parameters des Betriebspunktes der Erfassung (A) zugeordnet ist.

12. Verfahren gemäß Anspruch 11, bei dem die vorbestimmte Korrekturmarge in einem Speicher des Schaltkreises gespeichert ist oder ausgehend von einer in dem Schaltkreis gespeicherten funktionalen Relation berechnet ist; wobei die gespeicherten Werte oder die gespeicherte funktionale Relation durch die Umsetzung eines Kalibrierungsverfahrens gemäß einem der Ansprüche 1 bis 10 erhalten werden.

13. Verfahren gemäß einem der Ansprüche 11 und 12, bei dem die Schritte e) bis g) für mehrere Werte des ersten Parameters (V1, F1) umgesetzt sind.

14. Verfahren gemäß irgendeinem der Ansprüche 11 bis 13, bei dem, wenn der Schaltkreis (300) eine Vielzahl von Sensoren für Zeitfehler (304) vom präventiven Typ, die jeweils mit einem (302) der Sequenzelemente gekoppelt sind, umfasst, die Schritte e) bis g) für jeden Sensor derart umgesetzt sind, dass eine Vielzahl von korrigierten Betriebspunkten (A', B', C') erhalten wird, die denselben Wert wie der erste Parameter (V1, F1) haben, wobei das Verfahren darüber hinaus ausgehend von der Vielzahl von korrigierten Betriebspunkten (A', B', C') einen Bestimmungsschritt eines einzigartigen optimalen Betriebspunktes (A'), der dem betrachteten Wert des ersten Parameters zugeordnet ist, umfasst.

15. Verfahren gemäß Anspruch 14, bei dem der einzigartige optimale Betriebspunkt durch den genannten Wert des ersten Parameters (V1, F1) und ein arithmetisches Mittel der genannten Werte des zweiten Parameters ($F_{max1}$, $F_{max2}$, $F_{max3}$, $V_{min1}$, $V_{min2}$, $V_{min3}$) der Vielzahl von korrigierten Betriebspunkten (A', B', C') definiert ist.

16. Verfahren gemäß Anspruch 14, bei dem der zweite Parameter die Frequenz des Uhrensignals (F) ist und der einzigartige optimale Betriebspunkt (A') durch den genannten Wert des ersten Parameters (V1) und des niedrigsten ($F_{max1}$) der genannten Werte des zweiten Parameters der Vielzahl von korrigierten Betriebspunkten (A', B', C') definiert ist.

17. Verfahren gemäß Anspruch 14, bei dem der zweite Parameter die Versorgungsspannung (V) des digitalen Schaltkreises (300) ist und der einzigartige optimale Betriebspunkt (A') durch den genannten Wert des ersten Parameters (F1) und den größten ($V_{min1}$) der genannten Werte des zweiten Parameters der Vielzahl von korrigierten Betriebspunkten (A', B', C') definiert ist.

18. Verfahren gemäß irgendeinem der Ansprüche 1 bis 17, bei dem das Erfassungsfenster (W) vor einer aktiven Front des Uhrensignals (CLK) angeordnet ist.

19. Verfahren gemäß irgendeinem der Ansprüche 1 bis 18, bei dem das Erfassungsfenster (W) zwischen 10 % und 50 % einer Periode des Uhrensignals (CLK) wert ist.

20. Digitaler, elektronischer Schaltkreis, umfassend:

- eine Vielzahl von Sequenzelementen (301, 302);
- Leitpfade der Daten (303) zwischen den Sequenzelementen, wobei wenigstens einer der Leitpfade der Daten (303) in Bezug auf die Verbreitungsfrist der Daten kritisch ist;

- einen Uhrenbaum (305), der ein Uhrensignal (CLK) zum Takten der Sequenzelemente ausgibt; und
- einen Sensor für Zeitfehler (304) vom präventiven Typ, der an eines der Sequenzelemente (302) gekoppelt ist und am Eingang ein Datensignal (D) empfängt, das auf dem Sequenzelement eintrifft und konfiguriert ist, um während eines Erfassungsfensters (W) einen Übergang des Datensignals (D) zu erfassen;
- Einstellmittel wenigstens eines ersten und eines zweiten Betriebsparameters des digitalen Schalkreises;

**dadurch gekennzeichnet, dass** es einen Controller umfasst, der konfiguriert ist, um bei einer Charakterisierungsphase die folgenden Schritte umzusetzen:

e) Aktivierung eines Leitpfades der Daten (303) bis zum an den Sensor (304) gekoppelten Sequenzelement (302);
f) für einen bestimmten Datenwert des ersten Parameters (V1, F1) Bestimmung eines ersten Wertes ($F_{d1}$, $V_{d1}$) des zweiten Parameters, von dem aus der Sensor während des Erfassungsfensters einen Übergang des Datensignals erfasst, wobei die genannten Werte des ersten (V1, F1) und zweiten ($F_{d1}$, $V_{d1}$) Parameters einen Betriebspunkt der Erfassung (A) des digitalen Schaltkreises definieren;
g) Bestimmung eines optimalen Betriebspunktes (A'), der dem Betriebspunkt der Erfassung zugeordnet ist, durch Hinzufügen einer vorbestimmten Korrekturmarge ($\Delta F_1$, $\Delta V_1$) zu dem ersten Wert ($F_{d1}$, $V_{d1}$) des zweiten Parameters im Zusammenhang mit einem Grenzwert des zweiten Parameters, der eine Störung des digitalen Schaltkreises nach sich ziehen würde, für den bestimmten Wert des ersten Parameters, wobei die genannte Korrekturmarge dem bestimmten Wert des ersten Parameters des Betriebspunktes der Erfassung (A) zugeordnet ist.

21. Schaltkreis gemäß Anspruch 20, bei dem der Controller darüber hinaus konfiguriert ist, um bei einer Kalibrierungsphase die folgenden Schritte umzusetzen:

a) Aktivierung eines Leitpfades der Daten (303) bis zum an den Sensor (304) gekoppelten Sequenzelement (302);
b) für einen bestimmten Datenwert des ersten Parameters (V1, F1) Bestimmung eines ersten Wertes ($F_{d1}$, $V_{d1}$) des zweiten Parameters, von dem aus der Sensor während des Erfassungsfensters einen Übergang des Datensignals erfasst, wobei die genannten Werte der ersten (V1, F1) und zweiten ($F_{d1}$, $V_{d1}$) Parameters einen Betriebspunkt der Erfassung (A) des digitalen Schaltkreises definieren;
c) für den genannten Wert des ersten Parameters (V1, F1) Bestimmung eines zweiten Wertes ($F_{M(c1)}$) des zweiten Parameters, ab dem der digitale Schaltkreis eine Störung aufweist;
d) für den Betriebspunkt der Erfassung (A) Berechnung einer Korrekturmarge ($\Delta F_{c1}$) gleich der Differenz zwischen den ersten (Fd1) und zweiten ($F_{M(C1)}$) Werten des zweiten Parameters;

22. Schaltkreis gemäß einem der Ansprüche 20 und 21, umfassend:

- eine Online-Verfolgungseinrichtung (1200) des Betriebs des digitalen Schaltkreises (300), umfassend eine Kette von Verzögerungszellen (1320; 1330), deren Verbreitungsfrist auf dieselbe Weise variiert wie die Verbreitungsfrist durch den kritischen Pfad und die konfiguriert ist, um eine digitale Signatur (SIG) auszugeben, die ein Verhältnis zwischen der Periode des genannten Uhrensignals (CLK) und der Verbreitungsfrist durch den kritischen Pfad darstellt; und
- ein Verarbeitungsmodul (1210), das konfiguriert ist, um die digitale Signatur (SIG), die aus der Verfolgungsvorrichtung (1200) hervorgegangen ist, mit einer Referenzsignatur ($SIG_{REF}$) zu vergleichen, wobei das Ergebnis des Vergleichs verwendet wird, um die Einstellmittel des ersten und zweiten Betriebsparameters (F, V, $V_{bias}$) zu steuern.

23. Schaltkreis gemäß Anspruch 22, bei dem der genannte Controller darüber hinaus konfiguriert ist, um eine Gruppe von optimalen Betriebspunkten ($F_{opt}(V)$, V) des digitalen Schaltkreises zu bestimmen, wobei die Gruppe der optimalen Betriebspunkte eine optimale Betriebskurve ($F_{opt}(V)$) bildet, die jeweils Bereiche des gewünschten und nicht gewünschten Betriebs begrenzt und in der der genannte Controller darüber hinaus konfiguriert ist, um:

- Abschnitte der optimalen Betriebskurve ($F_{opt}(V)$ festzustellen, für die die digitale Signatur (SIG), die von der Online-Verfolgungsvorrichtung (1200) ausgegeben wird, einen einzigen Wert hat;
- in einem Speicher (1220), der mit dem Bearbeitungsmodul (1210) gekoppelt ist, einen Bereich von Betriebspunkten abzuspeichern, der jedem festgestellten Abschnitt und der zugeordneten Referenzsignatur entspricht, wobei die zugeordnete Referenzsignatur von dem Wert der digitalen Signatur abhängt, der von der Online-Verfolgungsvorrichtung für die Betriebspunkte des festgestellten Abschnitts ausgegeben wird;
- in dem Speicher (1220) Auswahl der Referenzsignatur, die dem Bereich von Betriebspunkten zugeordnet ist, die einen gebräuchlichen Betriebspunkt (W) des digitalen Schaltkreises einschließt, wobei die ausgewählte Referenzsignatur von dem Bearbeitungsmodul (1210) verwendet wird, um die Einstellmittel der Betriebsparameter zu steuern.

**Claims**

1. Method for calibrating a digital circuit (300) comprising:

   - a plurality of sequential elements (301, 302);
   - data conducting paths (303) between the sequential elements;
   - a clock tree (305) delivering a clock signal (CLK) for clocking the sequential elements; and
   - a time fault sensor (304) of preventive type coupled to one (302) of the sequential elements, receiving as input a data signal (D) arriving at the sequential element and configured to detect during a detection window (W) a transition of the data signal (D);
   - means for setting at least one first and one second operating parameter of the digital circuit;

   the method is **characterised by** the following steps:

   a) activating a data conducting path (303) up to the sequential element (302) coupled to the sensor (304);
   b) determining, for a given value of the first parameter (V1, F1), a first value ($F_{d1}$, $V_{d1}$) of the second parameter from which the sensor detects a transition of the data signal during the detection window, said values of the first (V1, F1) and second ($F_{d1}$, $V_{d1}$) parameters defining a detection operating point (A) of the digital circuit;
   c) determining, for said value of the first parameter (V1, F1), a second value ($F_{M(c1)}$) of the second parameter above which the digital circuit is in malfunction;
   d) calculating, for the detection operating point (A), a correction margin ($\Delta F_{c1}$) equal to the difference between the first ($F_{d1}$) and second values ($F_{M(c1)}$) of the second parameter.

2. Method according to claim 1, wherein steps a) to d) are carried out for a plurality of control circuits having a structure identical to the digital circuit (300), for a same given value of the first parameter, so as to obtain several correction margins ($\Delta F_{c1}$, $\Delta F_{c2}$, $\Delta F_{c3}$) relative to the sensor (304), and further comprising a step of determining an optimum correction margin ($\Delta F_1$) associated with the value of the first parameter of the detection operating points (A1 ; A2 ; A3) from correction margins ($\Delta F_{c1}$, $\Delta F_{c2}$, $\Delta F_{c3}$) relative to the sensor (304).

3. Method according to claim 2, wherein the optimum correction margin ($\Delta F_1$) is an arithmetic mean of the correction margins ($\Delta F_{c1}$, $\Delta F_{c2}$, $\Delta F_{c3}$) relative to the sensor (304).

4. Method according to claim 2, wherein the optimum correction margin ($\Delta F_1$) is the lowest ($\Delta F_{c1}$) of the correction margins relative to the sensor (304).

5. Method according to any of claims 1 to 4, wherein one of the first and second parameters is chosen from among the frequency and the period of the clock signal and wherein the other of the first and second parameters is chosen from among the supply voltage and the bias voltage of the digital circuit.

6. Method according to claim 5, wherein the second parameter is the frequency of the clock signal (F) and each correction margin ($\Delta F_{c1}$, $\Delta F_{c2}$, $\Delta F_{c3}$) is a frequency margin.

7. Method according to claim 5, wherein the second parameter is the period of the clock signal and each correction margin is a time margin.

8. Method according to claim 5, wherein the second parameter is chosen from among the supply voltage (V) and the bias voltage ($V_{bias}$) of the digital circuit and each correction margin ($\Delta V_{c1}$) is a voltage margin.

9. Method according to any of claims 1 to 8, wherein the second value ($F_{M(c1)}$) of the second parameter is obtained by activating a critical data conducting path (303) and by modifying progressively the second parameter (F, V) up to causing a time violation of the data signal (D) received by the sequential element (302) arranged on the critical path, with respect to an active edge of the clock signal (CLK).

10. Method according to any of claims 1 to 9, wherein steps a) to d) are carried out for several values of the first parameter (V1, F1).

11. Method for characterizing an integrated circuit consisting in determining at a given instant of the life of the circuit an optimum operating point (A') of the digital circuit comprising:

- a plurality of sequential elements (301, 302);
- data conducting paths (303) between the sequential elements;
- a clock tree (305) delivering a clock signal (CLK) for clocking the sequential elements; and
- a time fault sensor (304) of preventive type coupled to one (302) of the sequential elements, receiving as input a data signal (D) arriving at the sequential element and configured to detect, during a detection window (W), a transition of the data signal (D),
- means for setting at least one first and one second operating parameter of the digital circuit,

the method is **characterised by** the following steps:

e) activating a data conducting path (303) up to the sequential element (302) coupled to the sensor (304),
f) determining, for a given value of the first parameter (V1, F1), a first value ($F_{d1}$, $V_{d1}$) of the second parameter from which the sensor detects a transition of the data signal during the detection window, said values of the first (V1, F1) and second ($F_{d1}$, $V_{d1}$) parameters defining a detection operating point (A) of the digital circuit,
g) determining an optimum operating point (A') associated with the detection operating point, by adding to the first value ($F_{d1}$, $V_{d1}$) of the second parameter, a predetermined correction margin ($\Delta F_1$, $\Delta V_1$,) in relation with a limit value of the second parameter which would lead to a malfunction of the digital circuit, for the given value of the first parameter, said correction margin being associated with the given value of the first parameter of the detection operating point (A).

12. Method according to claim 11, wherein the predetermined correction margin is memorised in a memory of the circuit or is calculated from a functional relation memorised in the circuit; the memorised values or the functional relation being obtained by the implementation of a calibration method according to one of claims 1 to 10.

13. Method according to one of claims 11 and 12, wherein steps e) to g) are carried out for several values of the first parameter (V1, F1).

14. Method according to any of claims 11 to 13, in which, when the circuit (300) comprises a plurality of time fault sensors (304) of preventive type each coupled to one (302) of the sequential elements, steps e) to g) are carried out for each sensor, so as to obtain a plurality of corrected operating points (A', B', C') having the same value of the first parameter (V1, F1), the method further comprising a step of determining, from the plurality of corrected operating points (A', B', C'), a single optimum operating point (A') associated with the considered value of the first parameter.

15. Method according to claim 14, wherein the single optimum operating point is defined by said value of the first parameter (V1, F1) and an arithmetic mean of said values of the second parameter ($F_{max1}$, $F_{max2}$, $F_{max3}$, $V_{min1}$, $V_{min2}$, $V_{min3}$) of the plurality of corrected operating points (A', B', C').

16. Method according to claim 14, wherein the second parameter is the frequency of the clock signal (F) and the single optimum operating point (A') is defined by said value of the first parameter (V1) and the lowest ($F_{max1}$ of said values of the second parameter of the plurality of corrected operating points (A', B', C').

17. Method according to claim 14, wherein the second parameter is the supply voltage (V) of the digital circuit (300) and the single optimum operating point (A') is defined by said value of the first parameter (F1) and the highest ($V_{min1}$) of said values of the second parameter of the plurality of corrected operating points (A', B', C').

18. Method according to any of claims 1 to 17, wherein the detection window (W) is located before an active edge of the clock signal (CLK).

19. Method according to any of claims 1 to 18, wherein the detection window (W) is between 10 % and 50 % of a period of the clock signal (CLK).

20. Digital electronic circuit comprising:

  - a plurality of sequential elements (301, 302);
  - data conducting paths (303) between the sequential elements, at least one of the data conducting paths (303) being critical in terms of data propagation delay,
  - a clock tree (305) delivering a clock signal (CLK) for clocking the sequential elements; and
  - a time fault sensor (304) of preventive type coupled to one (302) of the sequential elements, receiving as input a data signal (D) arriving at the sequential element and configured to detect, during a detection window (W), a transition of the data signal (D),
  - means for setting at least one first and one second operating parameter of the digital circuit,

  **characterized in that** it comprises a controller configured to implement, during a characterization phase, the following steps:

  e) activating a data conducting path (303) up to the sequential element (302) coupled to the sensor (304),
  f) determining, for a given value of the first parameter (V1, F1), a first value $(F_{d1}, V_{d1})$ of the second parameter from which the sensor detects a transition of the data signal during the detection window, said values of the first (V1, F1) and second $(F_{d1}, V_{d1})$ parameters defining a detection operating point (A) of the digital circuit,
  g) determining an optimum operating point (A') associated with the detection operating point, by adding to the first value $(F_{d1}, V_{d1})$ of the second parameter, a predetermined correction margin $(\Delta F_1, \Delta V_1)$ in relation with a limit value of the second parameter which would lead to a malfunction of the digital circuit, for the given value of the first parameter, said correction margin being associated with the given value of the first parameter of the detection operating point (A).

21. Circuit according to claim 20, wherein the controller is further configured to implement, during a calibration phase, the following steps:

  - activating a data conducting path (303) up to the sequential element (302) coupled to the sensor (304),
  - determining, for a given value of the first parameter (V1, F1), a first value $(F_{d1}, Vd_1)$ of the second parameter from which the sensor detects a transition of the data signal during the detection window, said values of the first (V1, F1) and second $(F_{d1}, V_{d1})$ parameters defining a detection operating point (A) of the digital circuit,
  - determining, for said value of the first parameter (V1, F1), a second value $(F_{M(c1)})$ of the second parameter above which the digital circuit is in malfunction;
  - calculating, for the detection operating point (A), a correction margin $(\Delta F_{c1})$ equal to the difference between the first $(F_{d1})$ and second values $(F_{M(c1)})$ of the second parameter.

22. Circuit according to one of claims 20 and 21, comprising:

  - a device for on-line monitoring (1200) the operation of the digital circuit (300), comprising a chain of delay cells (1320; 1330) of which the propagation delay varies in the same manner as the propagation delay through the critical path and configured to deliver a digital signature (SIG) representative of a ratio between the period of said clock signal (CLK) and the propagation delay through the critical path; and
  - a processing module (1210) configured to compare the digital signature (SIG) from the monitoring device (1200) with a reference signature $(SIG_{REF})$, the result of the comparison being used to command the means for setting the first and second operating parameters $(F, V, V_{bias})$.

23. Circuit according to claim 22, wherein said controller is further configured to determine a set of optimum operating points $(F_{opt}(V), V)$ of the digital circuit, the set of optimum operating points constituting an optimum operating curve $(F_{opt}(V))$ delimiting respectively desired and undesired operating zones, and wherein said controller is further configured to:

  - identify segments of the optimum operating curve $(F_{opt}(V))$ for which the digital signature (SIG) delivered by the on-line monitoring device (1200) has a single value;
  - record in a memory (1220) coupled to the processing module (1210) a zone of operating points corresponding to each identified segment and the associated reference signature, the associated reference signature being a function of the digital signature value delivered by the on-line monitoring device for the operating points of the identified segment;
  - selecting, in the memory (1220), the reference signature associated with the zone of operating points including a current operating point (W) of the digital circuit, the reference signature selected being used by the processing module (1210) to command the means for setting the operating parameters.

100

CLK

étage "amont"
D
101

étage "aval"

104

102

CLK-d

103

alerte

## Fig. 1

200

CLK

étage "amont"
101

étage "aval"

201

delai

102

CLK

103

alerte

## Fig. 2

**Fig. 3**

**Fig. 4A**

**Fig. 4B**

Fig. 5A

Fig. 5B

Fig. 5C

Fig. 6

**Fig. 7**

**Fig. 8**

**Fig. 9**

1 capteur, 6 circuits témoin

**Fig. 10**

6 circuits témoin

**Fig. 11**

**Fig. 12**

**Fig. 13A**

Temps d'échantillonage

**Fig. 13B**

**Fig. 14**

**Fig. 15**

## RÉFÉRENCES CITÉES DANS LA DESCRIPTION

**Documents brevets cités dans la description**

- WO 2010122036 A
- US 2010153896 A1, SEWALL JEREMY

- US 20080104561 A

**Littérature non-brevet citée dans la description**

- **Y. KUNITAKE et al.** Possibilities to Miss Predicting Timing Errors in Canary Flip-flops. *Institute of Electrical and Electronics Engineers,* 07 Janvier 2011